# EUROPEAN PATENT APPLICATION

(11) **EP 4 468 348 A1**
(43) Date of publication of application: **27.11.2024**
(21) Application number: 23743468.3
(22) Date of filing: 18.01.2023
(51) Int. Cl.: H01L 25/16, H01L 23/00, H01L 23/498

(54) **SEMICONDUCTOR PACKAGE**

(30) Priority: 18.01.2022 KR 20220007507
(71) Applicant: LG INNOTEK CO., LTD., Seoul 07796 (KR)
(72) Inventor: CHO, Hyun Dong, Seoul 07796 (KR); PARK, Duck Hoon, Seoul 07796 (KR)
(74) Representative: Plasseraud IP
(86) International application number: PCT/KR2023/000890
(87) International publication number: WO 2023/140622

(57) **Abstract**

A semiconductor package according to an embodiment comprises an insulating layer; and an electrode portion disposed on the insulating layer, wherein the electrode portion includes a plurality of pads and a trace connecting the plurality of pads, and wherein the plurality of pads includes a first pad including a curved portion in a circumference of an upper surface has a specific radius of curvature and a straight portion connected to the curved portion; and a second pad that does not include a straight portion in a circumference of an upper surface facing the curved portion of the first pad.

## Description

### [Technical Field]

An embodiment relates to a semiconductor package.

### [Background Art]

Electric/electronic products are progressing high-performance, and thus, technologies for placing more semiconductor devices in limited size semiconductor package substrates are proposed and studied. However, a general semiconductor package is based on a single semiconductor device, so there is a limit to the desired performance.

Accordingly, recently, a semiconductor package has been provided with multiple semiconductor devices using a plurality of substrates. Such a semiconductor package has a structure in which a plurality of semiconductor devices are connected in a horizontal and/or vertical direction on the substrate. Accordingly, the semiconductor package has the advantage of efficiently using a mounting area of the semiconductor device and transmitting the high-speed signal through a short signal transmission pass between semiconductor devices.

Because of these advantages, the semiconductor package as described above is applied to a mobile device.

In addition, a number of semiconductor devices and/or a size of each semiconductor device increases with the trend of high integration in a semiconductor package applied to a product that provides an internet of things (IoT), autonomous vehicles and high-performance servers, etc. or a concept of the semiconductor package is extended to a semiconductor chip-let by dividing a functional part of a semiconductor device.

Accordingly, mutual communication between semiconductor devices and/or semiconductor chip-lets is becoming important, and accordingly, there is a tendency to dispose an interposer between a substrate of a semiconductor package and a semiconductor device.

The interposer serves as a redistribution layer that gradually increases a width of a circuit pattern from the semiconductor device to the semiconductor package in order to facilitate mutual communication between semiconductor devices and/or semiconductor chip-lets or interconnect a semiconductor device and a semiconductor package substrate, and accordingly, it is possible to smoothly perform an electrical signal between the semiconductor package substrate having a relatively large circuit pattern compared to the circuit pattern of the semiconductor device and the semiconductor device.

The interposer may have an area equal to or greater than an entire area of the plurality of semiconductor devices and/or semiconductor chip-lets in order to mount the plurality of semiconductor devices and/or semiconductor chip-lets as a whole, or may be disposed only in a portion for interconnection between semiconductor devices and/or semiconductor chip-lets. That is, an area of the interposer may or may not increase as the number of semiconductor devices and/or semiconductor chip-lets increases. However, the area of the semiconductor package substrate tends to increase as the number of semiconductor devices and/or semiconductor chip-lets increases.

Meanwhile, the number of terminals of the semiconductor device is gradually increasing due to reasons such as 5G, Internet of Things (IOT), image quality increase, and communication speed increase. Accordingly, the number of mounting pads provided on the substrate is increasing.

However, although the number of terminals of the semiconductor device and the number of mounting pads provided on the substrate are increasing, the area of the substrate is limited, and accordingly, there is a problem in that it is not possible to place all mounting pads connected to terminals of semiconductor devices within a limited space. Accordingly, a conventional semiconductor package has a problem in that a circuit integration degree is deteriorated and signal transmission characteristics are deteriorated as a length of a trace connecting a plurality of mounting pads is increased.

### [Disclosure]

### [Technical Problem]

An embodiment provides a circuit board with a new structure and a semiconductor package comprising the same.

In addition, an embodiment provides a circuit board that can place a number of semiconductor devices side by side and a semiconductor package comprising the same.

In addition, an embodiment provides a circuit board that has changed a shape of a pad connected to a semiconductor device and a semiconductor package comprising the same.

In addition, an embodiment provides a circuit board that can improve electrical and/or physical reliability of a die bridge connecting a plurality of semiconductor devices and a semiconductor package comprising the same.

The technical problem to be solved in the embodiment is not limited to the technical problem mentioned above, and another technical problem not mentioned will be clearly understood by those of ordinary skill in the art to which the present invention belongs from the following description.

### [Technical Solution]

A semiconductor package according to an embodiment comprises an insulating layer; and an electrode portion disposed on the insulating layer, wherein the electrode portion includes a plurality of pads and a trace connecting the plurality of pads, and wherein the plurality of pads includes a first pad including a curved portion in a circumference of an upper surface has a specific radius of curvature and a straight portion connected to the curved portion; and a second pad that does not include a straight portion in a circumference of an upper surface facing the curved portion of the first pad.

In addition, the first pad includes a width in a second direction parallel to the straight portion and a width in a first direction perpendicular to the second direction, and wherein the width in the first direction is smaller than the width in the second direction.

In addition, a width of the first pad in a-first direction from a center of the radius of curvature is smaller than each width of the first pad in a + first direction, a-second direction, and a +second direction from the center of the radius of curvature.

In addition, widths of the first pad in the + first direction,-second direction, and + second direction from the center of the radius of curvature are the same, respectively.

In addition, a width of the first pad in a first direction satisfies a range of 80% to 95% of a width of the first pad in a second direction.

In addition, the width in the first direction satisfies a range of 16 µm to 76 µm, and the width in the second direction satisfies a range of 20 µm to 80µm.

In addition, a line width of the trace satisfies a range of 1 µm to 6 µm, and a spacing between the pad and the trace or a spacing between the plurality of traces satisfies a range of 1 µm to 6 µm.

In addition, the straight portion of the first pad is parallel to an extension direction of a trace connected to the second pad.

In addition, the first and second pads are spaced apart from each other in the first direction, and the trace extends between the first and second pads in the second direction.

In addition, at least two traces extending in the second direction and spaced apart from each other in the first direction are disposed between the first pad and the second pad.

In addition, two traces are disposed between the first pad and the second pad, and a pitch between the first pad and the second pad satisfies a range of 25 µm to 110 µm.

In addition, two traces are disposed between the first pad and the second pad, and a spacing between the first pad and the second pad satisfies a range of 5 µm to 30 µm.

In addition, the straight portion of the first pad is arranged adjacent to the trace, and a curved portion of the second pad faces the straight portion of the first pad with the trace interposed therebetween.

In addition, the electrode portion further includes a dummy electrode electrically separated from the pad and the trace.

In addition, the semiconductor package further comprises a first connection portion disposed on a first electrode part of the electrode portion; a second connection portion disposed on a second electrode part of the electrode portion; a first semiconductor device disposed on the first connection portion; and a second semiconductor device disposed on the second connection portion, and wherein the trace connects the first electrode part connected to the first semiconductor device and the second electrode part connected to the second semiconductor device.

In addition, the first semiconductor device is a central processor (CPU), and the second semiconductor device is a graphics processor (GPU).

In addition, the electrode portion includes a third electrode part, wherein the semiconductor package further comprises: a third connection portion disposed on the third electrode part; and a third semiconductor device disposed on the third connection portion, wherein the third semiconductor device includes a memory chip.

In addition, a separation width between the first and second semiconductor devices satisfies a range of 60 µm to 150 µm.

### [Advantageous Effects]

The circuit board of an embodiment includes an electrode portion connected to a semiconductor device. The electrode portion includes a pad and a trace. In this case, the pad has a shape in which a region adjacent to the trace is cut in a circle having a specific radius of curvature. For example, a circumference of an upper surface of the pad includes a curved portion having a specific radius of curvature and a straight portion connected to the curved portion. The straight portion may be referred to as a first portion of the circumference of the upper surface of the pad, and the curved portion may be referred to as a second portion of the circumference of the pad. In addition, the first portion is disposed adjacent to the trace. In addition, an extension direction of a straight line of the first portion may be the same direction as or parallel to an extension direction of the trace. Accordingly, the embodiment may secure an arrangement space for a plurality of traces between a plurality of pads spaced apart in the first direction D1 by changing a shape of the circumferential of the upper surface of the pads. Accordingly, the embodiment may allow the trace to be stably formed between a plurality of pads spaced apart in the first direction D1, and accordingly, physical and electrical reliability of the circuit board can be improved.

Meanwhile, the pad of the embodiment are divided into a plurality of groups. For example, the pad includes a first group of pads and a second group of pads. In this case, the first group of the pads are provided in a region having a relatively high density, and thus have a shape in which a region adjacent to the trace is cut from a circle having the specific radius of curvature. In contrast, the second group of the pads are provided in a region having a relatively low density, and thus may have a circular shape with a plane area larger than that of the first group of the pads. Accordingly, the embodiment can stably mount a semiconductor device, so that the semiconductor device can stably operate.

In addition, the circuit board of the embodiment includes a first substrate layer and a second substrate layer. The second substrate layer may include a PID, and thus may include a fine pattern having a line width and spacing corresponding to a plurality of different semiconductor devices mounted on a circuit board. Accordingly, the embodiment may allow a plurality of different semiconductor devices to be mounted on one circuit board, furthermore, it is possible to easily connect the plurality of semiconductor devices within a limited space. Accordingly, the embodiment can improve the performance of the application processor by separating the plurality of semiconductor devices according to their functions. In addition, the embodiment can easily connect a plurality of semiconductor devices within a limited space, so that a volume of a semiconductor package can be reduced, and thus an electronic device can be slimmed down.

In addition, the embodiment may be possible to minimize a distance between the first and second semiconductor devices disposed on the circuit board. Accordingly, the embodiment can minimize loss of a signal transmitted between the first and second semiconductor devices, so that product reliability can be improved.

In addition, the embodiment may mount a plurality of semiconductor devices side by side on one substrate, and thus, a thickness of the semiconductor package may be drastically reduced compared to the comparative example.

In addition, the embodiment does not require connection of a plurality of circuit boards to connect a plurality of semiconductor devices, and therefore, it can improve the convenience of a process and the reliability of an electrical connection.

### [Description of Drawings]

FIG. 1 is a view showing a circuit board according to a first embodiment.
FIG. 2 is a view showing a circuit board according to a second embodiment.
FIG. 3 is an enlarged view of a first substrate layer of a circuit board according to an embodiment.
FIG. 4 is a view showing in detail a layer structure of a first circuit pattern layer constituting a first substrate layer of a circuit board according to an embodiment.
FIG. 5 is an enlarged view of a second substrate layer of a circuit board according to an embodiment.
FIG. 6 is a view showing in detail a layer structure of a second circuit pattern layer constituting a second substrate layer according to an embodiment.
FIG. 7 is a plan view of an electrode portion according to an embodiment.
FIG. 8 is a view for comparing pad shapes of electrode portions of a comparative examples and an embodiment.
FIG. 9 is a view for explaining a problem caused by a pad shape of an electrode portion in a comparative example.
FIG. 10 is an enlarged view of one region of FIG. 7.
FIGS. 11 to 30 are views for explaining a circuit board of FIG. 1 in order of processes.
FIG. 31 is a view showing a semiconductor package according to a first embodiment.
FIG. 32 is a view showing a circuit board according to a second embodiment.
FIG. 33 is a view showing a semiconductor package according to a second embodiment.

### [Modes of the Invention]

Hereinafter, embodiments of the present invention will be described in detail with reference to the accompanying drawings.

However, the spirit and scope of the present invention is not limited to a part of the embodiments described, and may be implemented in various other forms, and within the spirit and scope of the present invention, one or more of the elements of the embodiments may be selectively combined and replaced.

In addition, unless expressly otherwise defined and described, the terms used in the embodiments of the present invention (including technical and scientific terms may be construed the same meaning as commonly understood by one of ordinary skill in the art to which this invention belongs, and the terms such as those defined in commonly used dictionaries may be interpreted as having a meaning that is consistent with their meaning in the context of the relevant art. Further, the terms used in the embodiments of the present invention are for describing the embodiments and are not intended to limit the present invention.

In this specification, the singular forms may also include the plural forms unless specifically stated in the phrase, and may include at least one of all combinations that may be combined in A, B, and C when described in "at least one (or more) of A (and), B, and C". Further, in describing the elements of the embodiments of the present invention, the terms such as first, second, A, B, (a), and (b) may be used.

These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

### -Electronic device -

Before describing the embodiment, an electronic device including the semiconductor package of the embodiment will be briefly described. The electronic device includes a main board (not shown). The main board may be physically and/or electrically connected to various components. For example, the main board may be connected to the semiconductor package of the embodiment. Various chips may be mounted on the semiconductor package. Broadly, memory chips such as volatile memory (eg DRAM), non-volatile memory (eg ROM), flash memory, and the like, an application processor chip such as a central processor (eg, CPU), a graphics processor (eg, GPU), a digital signal processor, an encryption processor, a microprocessor, and a microcontroller, and a logic chip such as an analog-to-digital converter or an application-specific IC (ASIC) may be mounted on the semiconductor package.

In addition, the embodiment provides a semiconductor package capable of mounting at least two different types of chips on one substrate while reducing the thickness of the semiconductor package connected to the main board of the electronic device.

In this case, the electronic device may be a smart phone, a personal digital assistant, a digital video camera, a digital still camera, a network system, computer, a monitor, a tablet, a laptop, a netbook, a television, a video game, a smart watch, an automotive, or the like. However, the embodiment is not limited thereto, and may be any other electronic device that processes data in addition to these.

### -Embodiment -

Hereinafter, a circuit board according to an embodiment and a package substrate including the circuit board will be described in detail.

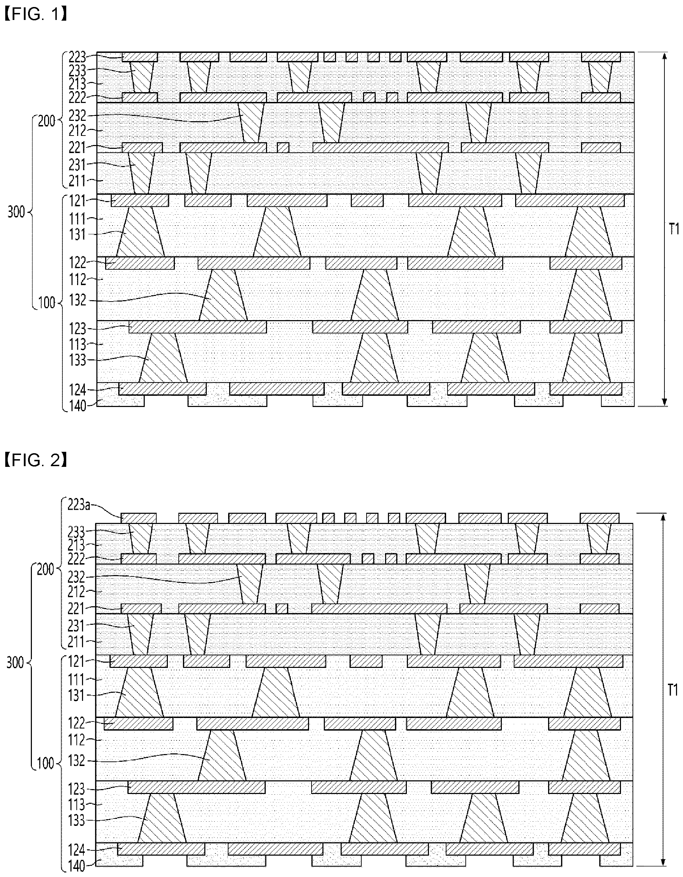

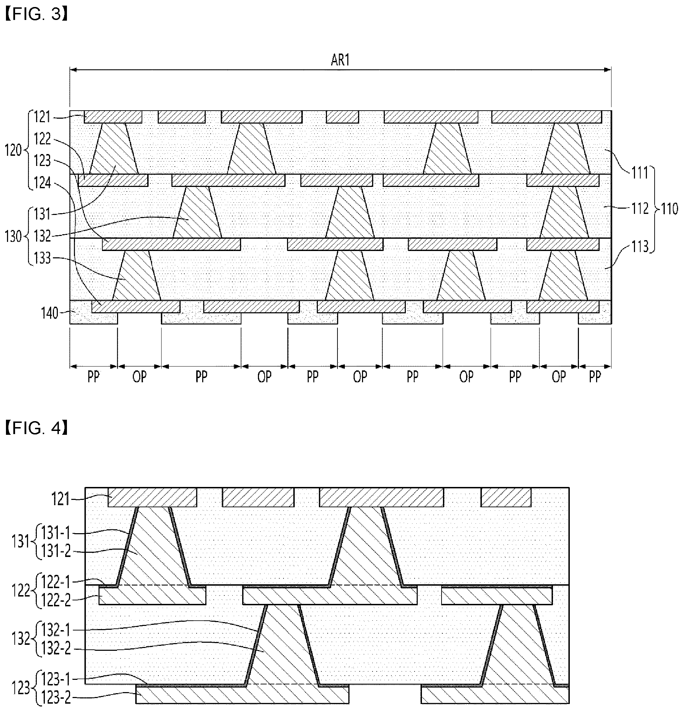

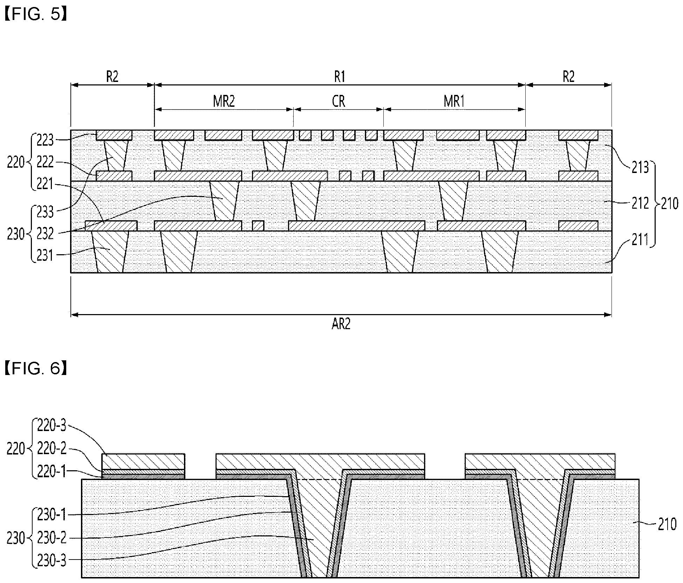

FIG. 1 is a view showing a circuit board according to a first embodiment, FIG. 2 is a view showing a circuit board according to a second embodiment, FIG. 3 is an enlarged view of a first substrate layer of a circuit board according to an embodiment, FIG. 4 is a view showing in detail a layer structure of a first circuit pattern layer constituting a first substrate layer of a circuit board according to an embodiment, FIG. 5 is an enlarged view of a second substrate layer of a circuit board according to an embodiment, and FIG. 6 is a view showing in detail a layer structure of a second circuit pattern layer constituting a second substrate layer according to an embodiment.

Hereinafter, features of a circuit board 300 according to an embodiment will be schematically described with reference to FIGS. 1 to 6.

Referring to FIGS. 1 to 6, the circuit board 300 includes a plurality of substrate layers.

The circuit board 300 allows at least two different semiconductor devices to be mounted.

The circuit board 300 includes an electrode portion electrically connected to at least two semiconductor devices.

The electrode portion includes a plurality of pads each connected to at least two semiconductor devices and a trace electrically connecting the plurality of pads. In addition, an electrode portion including a plurality of pads and a trace may be referred to as a die bridge.

The circuit board 300 includes a first substrate layer 100 and a second substrate layer 200.

The first substrate layer 100 may have a multi-layer structure. For example, the first substrate layer 100 may have at least a two-layer structure. For example, the first substrate layer 100 includes at least two insulating layers. The first substrate layer 100 may be referred to as an one side portion of a circuit board connected to a main board of an electronic device.

A second substrate layer 200 is disposed on the first substrate layer 100.

For example, the second substrate layer 200 may be referred to as the other side portion of a circuit board connected to a semiconductor device.

The second substrate layer 200 may have a multi-layer structure, but is not limited thereto. For example, the second substrate layer 200 may include at least two insulating layers. The second substrate layer 200 provides a region where at least two semiconductor devices are mounted.

The first substrate layer 100 includes a plurality of insulating layers.

For example, the first substrate layer 100 may include a first-first insulating layer 111, a first-second insulating layer 112, and a first-third insulating layer 113, but is not limited thereto.

The first-first insulating layer 111, the first-second insulating layer 112, and the first-third insulating layer 113 may include the same insulating material, but are not limited thereto.

For example, each of the first-first insulating layer 111, the first-second insulating layer 112, and the first-third insulating layer 113 may include the same first insulating material. For example, the first-first insulating layer 111, the first-second insulating layer 112, and the first-third insulating layer 113 may be provided as a prepreg.

Each of the first-first insulating layer 111, the first-second insulating layer 112, and the first-third insulating layer 113 may have a thickness ranging from 10 µm to 30 µm. For example, each of the first-first insulating layer 111, the first-second insulating layer 112, and the first-third insulating layer 113 may satisfy a range of 15 µm to 25 µm. For example, each of the first-first insulating layer 111, the first-second insulating layer 112, and the first-third insulating layer 113 may satisfy a range of 18 µm to 23 µm. Here, the thickness of the insulating layer may mean a vertical distance between circuit pattern layers disposed on different layers.

The first substrate layer 100 includes a first circuit pattern layer 120.

In this case, the circuit pattern layer 120 of the first substrate layer 100 may have an embedded trace substrate (ETS) structure. For example, a circuit pattern layer disposed on an uppermost side of the first substrate layer 100 may have a structure buried in an insulating layer of the first substrate layer 100.

For example, the first substrate layer 100 includes a first-first circuit pattern layer 121 buried on an upper surface of the first-first insulating layer 111. The first-first circuit pattern layer 121 may have an ETS structure. For example, an upper surface of the first-first circuit pattern layer 121 and an upper surface of the first-first insulating layer 111 may be positioned on the same plane. A side surface and lower surface of the first-first circuit pattern layer 121 may be covered with the first-first insulating layer 111.

That is, the first-first circuit pattern layer 121 is a circuit pattern layer disposed closest to the second substrate layer 200 in a vertical direction among the first circuit pattern layers 120 disposed on the first substrate layer 100. The first-first circuit pattern layer 121 has an ETS structure. That is, the first-first circuit pattern layer 121 is manufactured by a ETS method, and thus may be buried in the first-first insulating layer 111.

The ETS structure enables miniaturization of the circuit pattern layer compared to a circuit pattern layer of a structure protruding on an insulating layer.

Accordingly, the embodiment can minimize a difference in line width or spacing between the first circuit pattern layer 120 and a second circuit pattern layer 220 disposed on the second substrate layer 200. That is, the second circuit pattern layer 220 of the second substrate layer 200 has a width and spacing corresponding to a width and spacing of terminals of a semiconductor device as will be described below.

In this case, when the difference in line width between the second circuit pattern layer 220 and the first-first circuit pattern layer 121 (Clearly, a line width of a trace of the second circuit pattern layer and a line width of a trace of the first-first circuit pattern layer) is great, signal transmission loss increases due to a width difference, and thus signal transmission characteristics may deteriorate. Therefore, the embodiment provides the first-first circuit pattern layer 121 have an ETS structure, and accordingly, a difference in line width and/or spacing between the first-first circuit pattern layer 121 and the second circuit pattern layer 220 is minimized. Accordingly, the embodiment can minimize signal transmission loss that may occur due to a difference in line width and/or spacing between the second circuit pattern layer and the first-first circuit pattern layer 121. Furthermore, the embodiment changes the line width and/or spacing of each layer of the second circuit pattern layer 220 described below, so that the difference in line width and/or spacing between the first circuit pattern layer and the second circuit pattern layer to be further minimized.

The first substrate layer 100 includes a first-second circuit pattern layer 122 disposed under a lower surface of the first-first insulating layer 111. The first-second circuit pattern layer 122 protrudes downward from a lower surface of the first-first insulating layer 111. Side and lower surfaces of the first-second circuit pattern layer 122 are covered with the first-second insulating layer 112.

The first substrate layer 100 includes a first-third circuit pattern layer 123 disposed under a lower surface of the first-second insulating layer 112. The first-third circuit pattern layer 123 protrudes downward from a lower surface of the first-second insulating layer 112. Side and lower surfaces of the first-third circuit pattern layer 123 are covered with the first-third insulating layer 113.

The first substrate layer 100 includes a first-fourth circuit pattern layer 124 disposed under a lower surface of the first-third insulating layer 113. The first-fourth circuit pattern layer 124 protrudes downward from a lower surface of the first-third insulating layer 113.

A first circuit pattern layer 120 including a first-first circuit pattern layer 121, a first-second circuit pattern layer 122, a first-third circuit pattern layer 123 and a first-fourth circuit pattern layer 124 may be formed of at least one metal material selected from among gold (Au), silver (Ag), platinum (Pt), titanium (Ti), tin (Sn), copper (Cu), and zinc (Zn). In addition, the first circuit pattern layer may be formed of paste or solder paste including at least one metal material selected from among gold (Au), silver (Ag), platinum (Pt), titanium (Ti), tin (Sn), copper (Cu), and zinc (Zn), which are excellent in bonding strength. Preferably, the first circuit pattern layer 120 may be formed of copper (Cu) having high electrical conductivity and a relatively low cost.

A first circuit pattern layer 120 including a first-first circuit pattern layer 121, a first-second circuit pattern layer 122, a first-third circuit pattern layer 123 and a first-fourth circuit pattern layer 124 includes a pad and a trace. The pad may include a through electrode pad connected to a through electrode, and a core pad or BGA pad on which a connection portion (to be described later) is disposed that is connected to the main board of the electronic device. The trace may refer to a wiring in a form of a long line that transmits an electrical signal while being connected to the pad. A pad (eg, through electrode pad) of the first circuit pattern layer 120 may have a width ranging from 20 µm to 90 µm. The pad of the first circuit pattern layer 120 may have a width ranging from 22 µm to 85 µm. The pad of the first circuit pattern layer 120 may have a width ranging from 25 µm to 80 µm. For example, the first substrate layer 100 includes a first through electrode disposed in each insulating layer. In this case, the first insulating layer 110 is formed of prepreg containing reinforcing fibers. Accordingly, the first through electrode in the first insulating layer 110 have a size of at least 15 µm or more. Accordingly, the pad of the first circuit pattern layer 120 may have a width greater than that of the first through electrode in order to be connected to the first through electrode.

A line width of a trace of the first circuit pattern layer 120 may satisfy a range of 6 µm to 20 µm. For example, a line width of a trace of the first circuit pattern layer 120 may satisfy a range of 7 µm to 15 µm. For example, a line width of the trace of the first circuit pattern layer 120 may satisfy a range of 8 µm to 12 µm. In addition, a spacing between traces of the first circuit pattern layer 120 may satisfy a range of 6 µm to 20 µm. For example, a spacing between traces of the first circuit pattern layer 120 may satisfy a range of 7 µm to 15 µm. For example, a spacing between traces of the first circuit pattern layer 120 may satisfy a range from 8 µm to 12 µm.

In addition, the first substrate layer 100 includes a first through electrode 130 disposed in the first insulating layer 110. The first through electrode 130 may be formed to pass through one first insulating layer, or may be formed to pass through at least two first insulating layers in common.

The first through electrode 130 includes a first-first through electrode 131 passing through the first-first insulating layer 111. The first through electrode 130 includes a first-second through electrode 132 passing through the first-second insulating layer 112. The first through electrode 130 includes a first-third through electrode 133 passing through the first-third insulating layer 113.

The first-first through electrode 131, the first-second through electrode 132, and the first-third through electrode 133 may have the same shape as each other. For example, the first-first through electrode 131, the first-second through electrode 132, and the first-third through electrode 133 may have trapezoidal shapes with a width of an upper surface and a width of a lower surface different from each other. Preferably, each of the first-first through electrode 131, first-second through electrode 132, and first-third through electrode 133 have a width of an upper surface smaller than a width of a lower surface.

Each of the first-first through electrode 131, first-second through electrode 132, and first-third through electrode 133 may have a width ranging from 15 µm to 70 µm. Each of the first-first through electrode 131, first-second through electrode 132, and first-third through electrode 133 may have a width ranging from 18 µm to 65 µm. Each of the first-first through electrode 131, first-second through electrode 132, and first-third through electrode 133 may have a width ranging from 20 µm to 60 µm. The width of each of the first-first through electrode 131, first-second through electrode 132, and first-third through electrode 133 may refer to a width of a portion having a relatively large width among upper and lower surfaces of each of the first-first through electrode 131, first-second through electrode 132, and first-third through electrode 133.

The first circuit pattern layer 120 and the first through electrode 130 have a multi-layer structure. However, one of the first circuit pattern layers 120 of the embodiment has an ETS structure and, and accordingly, the circuit pattern layer of the ETS structure may have a layer structure different from that of the other circuit pattern layers.

For example, the first-first circuit pattern layer 121 may have a layer structure different from those of the first-second circuit pattern layer 122 and the first-third circuit pattern layer 123. For example, a number of layers of the first-first circuit pattern layer 121 may be different from a number of layers of each of the first-second circuit pattern layer 122 and the first-third circuit pattern layer 123. For example, the number of layers of the first-first circuit pattern layer 121 may be smaller than that of each of the first-second circuit pattern layer 122 and the first-third circuit pattern layer 123.

For example, the first-first circuit pattern layer 121 may include only a second metal layer (eg, an electrolytic plating layer). Alternatively, the first-second circuit pattern layer 122 may include a first metal layer (122-1, for example, a seed layer) and a second metal layer 122-2 (for example, an electrolytic plating layer). In addition, the first-third circuit pattern layer 123 may include a first metal layer 123-1 and a second metal layer 123-2. This is because a seed layer of the first-first circuit pattern layer 121 is finally removed in a process of manufacturing the circuit board.

The first-first through electrode 131 includes a first metal layer 131-1 and a second metal layer 131-2 corresponding to the first-second circuit pattern layer 122. In addition, the first-second through electrode 132 includes a first metal layer 132-1 and a second metal layer 132-2 corresponding to the first-third circuit pattern layer 123.

The first substrate layer 100 includes a protective layer 140. The protective layer 140 may protect an insulating layer and a circuit pattern layer disposed on an outermost side of the first substrate layer 100. For example, the protective layer 140 may be disposed under a lower surface of the first-third insulating layer 113. The protective layer 140 may include an opening (not shown) exposing at least a part of a lower surface of the first-fourth circuit pattern layer 124 disposed under the lower surface of the first-third insulating layer 113.

Accordingly, a lower portion of the first substrate layer 100 includes a protection region PP covered by the protective layer 140 and an open region OP exposed through the opening of the protective layer 140. At least a part of the lower surface of the first-fourth circuit pattern layer 124 may be exposed to an outside of a substrate through an open region OP.

In addition, an upper portion of the first substrate layer 100 may include a first adhesion region or a first lamination region AR1. That is, second insulating layers constituting the second substrate layer 200 may be laminated or adhered on the first substrate layer 100.

In this case, the first substrate layer 100 includes an insulating layer including a reinforcing member (eg, glass fiber) to impart rigidity to the circuit board 300. The first substrate layer 100 may transmit signals transmitted from a second substrate layer 200 to a main board of an electronic device. Accordingly, the first substrate layer 100 may have specifications corresponding to specifications (eg, number of pads, spacing between pads, etc.) of a main board of an electronic device.

Meanwhile, the second substrate layer 200 is disposed on the first substrate layer 100. A plurality of insulating layers of the second substrate layer 200 may be sequentially laminated on the first-first insulating layer 111 of the first substrate layer 100.

In one embodiment, the second substrate layer 200 may be a redistribution layer (RDL), but is not limited thereto. The second substrate layer 200 provides a device mounting region in which a plurality of semiconductor devices are mounted.

The second substrate layer 200 transmits signals transmitted from the first substrate layer 100 to at least two semiconductor devices. In addition, the second substrate layer 200 may transmit signals acquired or processed by at least two semiconductor devices to the first substrate layer 100.

The second substrate layer 200 includes a plurality of layers, and each of the plurality of layers of the second substrate layer 200 may have a different wiring structure. Here, the wiring structure may include a line width of a circuit pattern layer, a spacing between circuit patterns, and a width of a through electrode.

A lower portion of the second substrate layer 200 includes a second lamination region AR2 laminated on the first lamination region AR1. In addition, an upper portion of the second substrate layer 200 includes a device mounting region in which a plurality of semiconductor devices are mounted. For example, the upper portion of the second substrate layer 200 includes a device mounting region R1 on which semiconductor devices are mounted, and a region R2 other than the device mounting region R1.

In addition, the device mounting region R1 includes a first mounting region MR1 in which a first semiconductor device is mounted. In addition, the device mounting region R1 includes a second mounting region MR2 in which a second semiconductor device is mounted. In addition, the device mounting region R1 includes a connection region CR connecting the first mounting region MR1 and the second mounting region MR2(Clearly, electrical connection between the first semiconductor device and the second semiconductor device).

For example, the first mounting region MR1 may be a region where a first processor chip is mounted, and the second mounting region MR2 may be a region where a second processor chip of a different type from the first processor chip is mounted. For example, the first processor chip may be any one of an application processor (AP) chip such as a central processor (eg, CPU), a graphic processor (eg, GPU), a digital signal processor, a cryptographic processor, a microprocessor, or a microcontroller. The second processor chip may be a processor chip of a different type from the first processor chip among application processor (AP) chips such as a microprocessor or microcontroller. For example, the first processor chip may be a central processor chip and the second processor chip may be a graphics processor chip. That is, the circuit board of the embodiment may be a circuit board for die splitting in which a plurality of processor chips, in which application processors are separated by function, are mounted on one board.

The second substrate layer 200 includes a fine pattern. For example, the circuit pattern layer of the second substrate layer 200 requires a line width of 6 µm or less, 5 µm or less, or 4 µm or less.

In addition, the circuit pattern layer of the second substrate layer 200 requires a spacing of 6 µm or less, 5 µm or less, or 4 µm.

For example, the circuit pattern layer provided in the device mounting region R1 of the second substrate layer 200 requires a line width of 1 µm to 6 µm, preferably 1.2 µm to 5 µm, more preferably 1.5 µm to 4 µm. In addition, the circuit pattern layer provided in the device mounting region R1 of the second substrate layer 200 of the embodiment requires a spacing of 1 µm to 6 µm, preferably 1.2 µm to 5 µm, more preferably 1.5 µm to 4 µm.

That is, functions required by application processors are increasing, and it is required to mount a plurality of semiconductor devices separated by function on one substrate. In addition, a number of terminals provided in each of a plurality of separated semiconductor devices is increasing.

In this case, when a separation distance between the plurality of semiconductor devices is great, a communication speed for mutual signal exchange may decrease. In addition, when a separation distance between the plurality of semiconductor devices is great, power consumption required for communication increases. In addition, when a separation distance between the plurality of semiconductor devices is great, a length of a trace connecting the plurality of semiconductor devices also increases, and thus it is vulnerable to noise and signal transmission loss increases.

That is, a distance between the plurality of semiconductor devices must be 150 µm or less. For example, a distance between the plurality of semiconductor devices must be 120 µm or less. For example, a distance between the plurality of semiconductor devices must be 100 µm or less.

Accordingly, the circuit pattern layer of the second substrate layer 200 requires a fine line width and a fine spacing in order to arrange all the wires connecting a plurality of semiconductor devices within a limited space.

The second substrate layer 200 may have a multi-layer structure. The second substrate layer 200 may have at least two or more layers based on the number of insulating layers. The second substrate layer 200 includes a second insulating layer 210.

The second insulating layer 210 may include a second-first insulating layer 211, a second-second insulating layer 212, and a second-third insulating layer 213, but the embodiment does not limit the number of layers of the second insulating layer. However, the embodiment allows the second insulating layer 210 to be composed of at least two layers, and accordingly, wiring between a plurality of semiconductor devices mounted in the device mounting region R1 can be smoothly connected.

A second-first insulating layer 211 is disposed on the first substrate layer 100. The second-first insulating layer 211 is disposed on the first-first insulating layer 111 of the first substrate layer 100. A second-second insulating layer 212 is disposed on the second-first insulating layer 211. In addition, a second-third insulating layer 213 is disposed on the second-second insulating layer 212.

In one embodiment, the second insulating layer 210 including the second-first insulating layer 211, the second-second insulating layer 212, and the second-third insulating layer 213 may include a second insulating material. For example, the second insulating layer 210 may include a second insulating material different from the first insulating material constituting the first insulating layer 110.

For example, the second insulating layer 210 may not include reinforcing fibers to enable a formation of a fine pattern. Preferably, the second insulating layer 210 may include a photocurable resin or a photosensitive resin. For example, the second insulating layer 210 may include photo imageable dielectics (PID).

The second insulating layer 210 of the second substrate layer 200 may include a photo-curable resin such as PID, thereby enabling miniaturization of a circuit pattern layer and a through electrode of the second substrate layer 200. However, the embodiment is not limited thereto, and the second insulating layer 210 of the second substrate layer 200 may include a thermosetting material not provided with a reinforcing fiber instead of a photocurable resin.

A thickness of each layer of the second insulating layer 210 may be smaller than a thickness of each layer of the first insulating layer 110. For example, each of the second-first insulating layer 211, the second-second insulating layer 212, and the second-third insulating layer 213 may have a thickness ranging from 3 µm to 20 µm. For example, each of the second-first insulating layer 211, the second-second insulating layer 212, and the second-third insulating layer 213 may have a thickness ranging from 4 µm to 18 µm. For example, each of the second-first insulating layer 211, the second-second insulating layer 212, and the second-third insulating layer 213 may have a thickness ranging from 6 µm to 15 µm. When the thickness of each of the second-first insulating layer 211, the second-second insulating layer 212, and the second-third insulating layer 213 is less than 3 µm, the second circuit pattern layer 220 formed on the second insulating layer 210 may not be stably protected. When the thickness of each of the second-first insulating layer 211, the second-second insulating layer 212, and the second-third insulating layer 213 exceeds 20 µm, miniaturization of the second circuit pattern layer 220 may be difficult.

The second substrate layer 200 may include a second circuit pattern layer 220. The second circuit pattern layer 220 is disposed on the second insulating layer 210.

The second circuit pattern layer 220 includes a second-first circuit pattern layer 221 disposed on the second-first insulating layer 211. The second circuit pattern layer 220 includes a second-second circuit pattern layer 222 disposed on the second-second insulating layer 212. The second circuit pattern layer 220 includes a second-third circuit pattern layer 223 disposed on the second-third insulating layer 213.

In this case, the second-third circuit pattern layer 223 may be a circuit pattern disposed on an uppermost side of the circuit board and may be buried in an insulating layer of the second substrate layer 200.

For example, the second-third circuit pattern layer 223 may be provided while filling a groove provided on an upper surface of the second-third insulating layer 213. Therefore, the embodiment can stably protect the second-third circuit pattern layer 223 disposed on an uppermost side of the second substrate layer 200. That is, the second-third circuit pattern layer 223 includes an electrode portion connected to a plurality of semiconductor devices. The electrode portion contains a trace with a relatively fine line width. When the trace of the second-third circuit pattern layer 223 has a structure protruding on the second-third insulating layer 213, cracks and/or peeling may occur due to various external factors. Accordingly, the embodiment has a structure in which the second-third circuit pattern layer 223 is buried in the second-third insulating layer 213. Accordingly, the embodiment may improve physical reliability and/or mechanical reliability.

However, embodiments are not limited thereto. For example, the second-third circuit pattern layer 223a may protrude on the upper surface of the second-third insulating layer 213 as shown in FIG. 2. As another example, the second-third circuit pattern layer 223a may protrude on the second-third insulating layer 213 while being partially buried in the second-third insulating layer 213.

The second circuit pattern layer 220 may have a layer structure different from that of the first circuit pattern layer 120. For example, the second circuit pattern layer 220 may have a greater number of layers than the number of layers of the first circuit pattern layer 120. However, the second circuit pattern layer 220 may have a smaller thickness than the first circuit pattern layer 120 while having a number of layers greater than that of the first circuit pattern layer 120.

Each of the second-first circuit pattern layer 221, the second-second circuit pattern layer 222, and the second-third circuit pattern layer 223 of the second circuit pattern layer 220 may have a three-layer structure. For example, each of the second-first circuit pattern layer 221, the second-second circuit pattern layer 222, and the second-third circuit pattern layer 223 includes a first metal layer 220-1, a second metal layer 220-2, and a third metal layer 220-3. The first metal layer 220-1 and the second metal layer 220-2 may be a seed layer.

The first metal layer 220-1 may be a titanium (Ti) layer formed by a sputtering process. The first metal layer 220-1 may have a thickness of 0.01 µm to 0.15 µm. For example, the first metal layer 220-1 may have a thickness of 0.03 µm to 0.12 µm. For example, the first metal layer 220-1 may have a thickness of 0.05 µm to 0.10 µm. The first metal layer 220-1 may be a first seed layer formed to increase adhesion between the second metal layer 220-2 and the third metal layer 220-3 and the second insulating layer 220.

The second metal layer 220-2 may be a copper (Cu) layer formed by a sputtering process. The second metal layer 220-2 may have a thickness of 0.01 µm to 0.35 µm. For example, the second metal layer 220-2 may have a thickness of 0.05 µm to 0.32 µm. For example, the second metal layer 220-2 may have a thickness of 0.1 µm to 0.3 µm. The second metal layer 220-2 may be a second seed layer formed to electrolytically plate the third metal layer 220-3. In an embodiment, a sum of the thicknesses of the first metal layer 220-1 and the second metal layer 220-2 may be 0.5 µm or less. Preferably, a sum of the thicknesses of the first metal layer 220-1 and the second metal layer 220-2 may be 0.4 µm or less. More preferably, a sum of the thicknesses of the first metal layer 220-1 and the second metal layer 220-2 may be 0.3 µm or less. When the sum of the thicknesses of the first metal layer 220-1 and the second metal layer 220-2 exceeds 0.5 µm, miniaturization of the second circuit pattern layer 220 may be difficult. Specifically, a process of manufacturing the second circuit pattern layer 220 includes a process of etching the first metal layer 220-1 and the second metal layer 220-2. In this case, when the thicknesses of the first metal layer 220-1 and the second metal layer 220-2 increase, an amount of etching in a process of etching increases, and thus miniaturization of the second circuit pattern layer 220 becomes difficult.

The seed layer of the second circuit pattern layer 220 includes a first metal layer 220-1 and a second metal layer 220-2. In this case, the first metal layer 220-1 and the second metal layer 220-2 are formed by a sputtering process, and thus have a smaller thickness than that of a seed layer of the first circuit pattern layer 120. Accordingly, it is possible to miniaturize the second circuit pattern layer 220.

The third metal layer 220-3 may be an electrolytic plating layer formed by electroplating the second metal layer 220-2 as a seed layer. The third metal layer 220-3 may have a thickness ranging from 2 µm to 12 µm. The third metal layer 220-3 may have a thickness ranging from 3 µm to 11 µm. The third metal layer 220-3 may have a thickness ranging from 4 µm to 10 µm.

When the thickness of the third metal layer 220-3 is less than 2 µm, the third metal layer 220-3 may also be etched in a process of etching the seed layer, and accordingly, normal implementation of the second circuit pattern layer 220 may be difficult. When the thickness of the third metal layer 220-3 is greater than 12 µm, miniaturization of the second circuit pattern layer 220 may be difficult.

Each of the second circuit pattern layer 220 may have a thickness ranging from 3 µm to 13 µm. Each of the second circuit pattern layer 220 may have a thickness ranging from 4 µm to 12 µm. Each of the second circuit pattern layer 220 may have a thickness ranging from 5 µm to 11 µm. When the thickness of the second circuit pattern layer 220 is less than 5 µm, resistance of the second circuit pattern layer increases, and thus electrical connection reliability between a plurality of semiconductor devices may deteriorate. When the thickness of each of the first circuit pattern layer 220 exceeds 11 µm, it may be difficult to implement fine patterns.

The second circuit pattern layer 220 may be an ultra-miniaturization pattern. For example, the second circuit pattern layer 220 may have a line width of 6 µm or less, 5 µm or less, or 4 µm or less. The second circuit pattern layer 220 may have a spacing of 6 µm or less, or 5 µm or less, or 4 µm or less.

The second circuit pattern layer 220 may have a line width of 1 µm to 6 µm. The line width may refer to a line width of a trace constituting the second circuit pattern layer 220. The second circuit pattern layer 220 may have a line width ranging from 1.2 µm to 5 µm. The second circuit pattern layer 220 may have a line width ranging from 1.5 µm to 4 µm. When the line width of the second circuit pattern layer 220 is smaller than 1 µm, the resistance of the second circuit pattern layer 220 increases, and thus, normal communication with a plurality of semiconductor devices may be difficult. In addition, when the line width of the second circuit pattern layer 220 is smaller than 1 µm, the rigidity of the second circuit pattern layer 220 is reduced, and thus mechanical reliability problems such as cracks may occur. When the line width of the second circuit pattern layer 220 is greater than 6 µm, it may be difficult to connect a plurality of semiconductor devices within a limited space. For example, when the line width of the second circuit pattern layer 220 is greater than 6 µm, it may be difficult to arrange all the electrode portions for connecting a plurality of semiconductor devices within a limited space. For example, when the line width of the second circuit pattern layer 220 is larger than 6 µm, an arrangement space for arranging a trace for connecting a plurality of semiconductor devices may increase, and accordingly, a size of the semiconductor package may increase..

The second circuit pattern layer 220 may have a spacing ranging from 1 µm to 6 µm. The spacing may mean a spacing between traces of the second circuit pattern layer 220. The second circuit pattern layer 220 may have a spacing ranging from 1.2 µm to 5 µm. The second circuit pattern layer 220 may have a spacing ranging from 1.5 µm to 4 µm. When the spacing between the second circuit pattern layers 220 is smaller than 1 µm, there is a problem in that an electrical short occurs because adjacent traces are connected to each other. For example, when the spacing of the second circuit pattern layer 220 is greater than 6 µm, it may be difficult to place all traces connected to a plurality of semiconductor devices within a limited space. For example, when the spacing between the second circuit pattern layers 220 is greater than 6 µm, a space for arranging traces for connecting a plurality of semiconductor devices may increase, and accordingly, a size of the semiconductor package may increase.

The line width and spacing of the second circuit pattern layer 220 described above may mean the line width and spacing of the second-third circuit pattern layer 223 disposed on an uppermost side of the second substrate layer 200. In addition, the second-first circuit pattern layer 221 and the second-second circuit pattern layer 222 may have the same line width and spacing as those of the second-third circuit pattern layer 223. However, the embodiment is not limited thereto, and the second-first circuit pattern layer 221 and the second-second circuit pattern layer 222 may have a line width and a spacing different from those of the second-third circuit pattern layer 223. For example, the second-first circuit pattern layer 221 and the second-second circuit pattern layer 222 may have a greater line width and a greater spacing than the second-third circuit pattern layer 223.

For example, a trace of the second-first circuit pattern layer 221 and a trace of the second-second circuit pattern layer 222 may have the same line width and spacing as a trace of the second-third circuit pattern layer 223. As another example, a trace of the second-first circuit pattern layer 221 and a trace of the second-second circuit pattern layer 222 may have a line width and a spacing different from those of the second-third circuit pattern layer 223. For example, the trace of the second-first circuit pattern layer 221 and the trace of the second-second circuit pattern layer 222 may have a line width and a spacing greater than those of the traces of the second-third circuit pattern layer 223.

In addition, the pad of the second-first circuit pattern layer 221 and the pad of the second-second circuit pattern layer 222 may have different widths from the pad of the second-third circuit pattern layer 223. For example, a pad of the second-first circuit pattern layer 221 and a pad of the second-second circuit pattern layer 222 may have a width greater than that of a pad of the second-third circuit pattern layer 223.

The second substrate layer 200 includes a second through electrode 230. The second through electrode 230 includes a second-first through electrode 231 passing through the second-first insulating layer 211. The second through electrode 230 includes a second through electrode 232 passing through the second insulating layer 212. The second through electrode 230 includes a second-third through electrode 233 passing through the second-third insulating layer 213.

The second-first through electrode 231, the second-second through electrode 232, and the second-third through electrode 233 may have different widths. For example, a through electrode positioned closest to the first substrate layer 100 among the second-first through electrode 231, the second-second through electrode 232, and the second-third through electrode 233 may have a greatest width. For example, a through electrode disposed farthest from the first substrate layer 100 (eg, a through electrode disposed closest to a plurality of semiconductor devices) among the second-first through electrode 231, second-second through electrode 232, and second-third through electrode 233 may have a smallest width.

However, each of the second-first through electrode 231, the second-second through electrode 232, and the second-third through electrode 233 may have a width smaller than that of the first through electrode 130. In this case, a width of the through electrode described below may mean a width of a surface having a relatively great width among upper and lower surfaces. For example, a width of each of the second-first through electrode 231, the second-second through electrode 232, and the second-third through electrode 233 mean a width of an upper surface of each of the second-first through electrode 231, the second-second through electrode 232 and the second-third through electrode 233.

The second-first through electrode 231, the second-second through electrode 232, and the second-third through electrode 233 of the embodiment is formed on the second-first insulating layer 211, the second-second insulating layer 212 and the second-third insulating layer 213 of the second insulating layer 210, respectively. In this case, the second-first insulating layer 211, the second-second insulating layer 212, and the second-third insulating layer 213 are composed of PID as described. Accordingly, a width of each of the second-first through electrode 231, the second-second through electrode 232, and the second-third through electrode 233 may be smaller than a width of the first through electrode 130 formed on the first insulating layer 110 .

For example, a width of each of the second-first through electrode 231, the second-second through electrode 232, and the second-third through electrode 233 may be less than 1/2 of a width of the first through electrode 130. For example, a width of each of the second-first through electrode 231, the second-second through electrode 232, and the second-third through electrode 233 may be less than 1/5 of a width of the first through electrode 130. For example, a width of each of the second-first through electrode 231, second-second through electrode 232, and second-third through electrode 233 may be less than 1/10 of a width of the first through electrode 130..

Specifically, since the first through electrode 130 is formed on the first insulating layer 110 composed of prepreg, it may have a width of at least 15 µm.

In contrast, the second-first through electrode 231, the second-second through electrode 232, and the second-third through electrode 233 are formed on the second insulating layer 210 composed of PID, so that it is possible to form about 1 µm.

As described above, a width of each of the second-first through electrode 231, second-second through electrode 232, and second-third through electrode 233 may have a level of 1/10 of a width of the first through electrode 130. In this case, when the second-first through electrode 231, the second-second through electrode 232, and the second-third through electrode 233 each have a level of 1/10 of the width of the first through electrode 130, signal transmission reliability may be reduced. For example, the first-first through electrode 131 and the second-first through electrode 231 are interconnected with the first-first circuit pattern layer 121 interposed therebetween. In this case, when the second-first through electrode 231 has a width of 1/10 of the first-first through electrode 131, resistance may increase due to a difference in width between the second-first through electrode 231 and the first-first through electrode 131, and thus reliability problems may occur. For example, signal transmission loss due to noise may increase in a process of transferring a signal from the second-first through electrode 231 to the first-first through electrode 131. In addition, when the transmitted signal is a high-frequency (mmWave) band (eg, 6GHz, 28GHz, 35GHz) or higher frequency signal of 5G or higher (6G, 7G ~ etc.), a bigger problem may occur in communication performance due to signal transmission loss.

For example, ae width of the second through electrode 230 in a region where the semiconductor device of the embodiment is mounted may have a fine width according to the widths of terminals included in the semiconductor device. In addition, a width of the second through electrode 230 may gradually increase as it approaches the first substrate layer 100. In addition, the second-first through electrode 231 disposed closest to the first substrate layer 100 among the second through electrode 230 may have a width corresponding to the first through electrode (eg, the first-first through electrode 131 ) formed on the first substrate layer 100.

For example, the first-first through electrode 131 may have a width ranging from 15 µm to 70 µm as described above.

In addition, a width of the second-first through electrode 231 disposed most adjacent to the first-first through electrode 131 in a vertical direction may correspond to a width of the first-first through electrode 131.

In addition, a width of the second through electrode 230 may gradually decrease as the distance from the first-first through electrode 131 increases in a vertical direction. In addition, the second-third through electrode 233 spaced farthest from the first-first through electrode 131 may have a smallest width among the second through electrode 230.

The second-second through electrode 232 disposed between the second-first through electrode 231 and the second-third through electrode 233 may be smaller than a width of the second-first through electrode 231 and greater than a width of the second-third through electrode 233. For example, a width of the second-second through electrode 232 may be a value between a width of the second-first through electrode 231 and a width of the second-third through electrode 233.

In the embodiment, the width of the second through electrodes 230 included in the second substrate layer 200 increases as it approaches the first substrate layer 100 and decreases as it moves away from the first substrate layer 100. Accordingly, the embodiment can minimize signal transmission loss caused by a difference in width of through electrodes provided on different layers, and accordingly, communication performance can be improved.

Meanwhile, a thickness T1 of the circuit board 300 of the embodiment may be smaller than that of a conventional circuit board.

For example, when the first substrate layer 100 has a 5-layer structure based on a number of layers of the first insulating layer and the second substrate layer 200 has a 3-layer structure based on a number of layers of the second insulating layer, the thickness T1 of the circuit board 300 may be 400 µm or less, 380 µm or less, or 360 µm or less.

Meanwhile, the first insulating layer 110 included in the first substrate layer 100 of the circuit board 300 may be composed of PID, which is the same photocurable resin as the second insulating layer 220 included in the second substrate layer 200.

However, when all insulating layers of the circuit board 300 are formed of PID, which is a photocurable resin, unit cost of the product may increase. That is, PID, which is a photocurable resin, is more expensive than prepreg, and accordingly, when the circuit board 300 is formed entirely of PID, the unit cost of the circuit board 300 and the semiconductor package including the circuit board 300 may increase. In addition, when the first insulating layers 110 of the first substrate layer 100 are also formed with PID, a problem may occur in the rigidity of the circuit board 300, and accordingly, warpage property may be deteriorated. Therefore, the embodiment allows the first substrate layer 100 to include the first insulating layer 110 made of prepreg.

Hereinafter, the second circuit pattern layer 220 disposed on the second substrate layer 200 will be described in more detail. That is, hereinafter, the second-third circuit pattern layer 223 of the second circuit pattern layer 220 on which a semiconductor device is mounted will be described in detail. The second-third circuit pattern layer 223 may be referred to as an electrode portion electrically connected to a semiconductor device. Accordingly, the second-third circuit pattern layer 223 will be referred to as an 'electrode portion' in the following description for convenience of explanation.

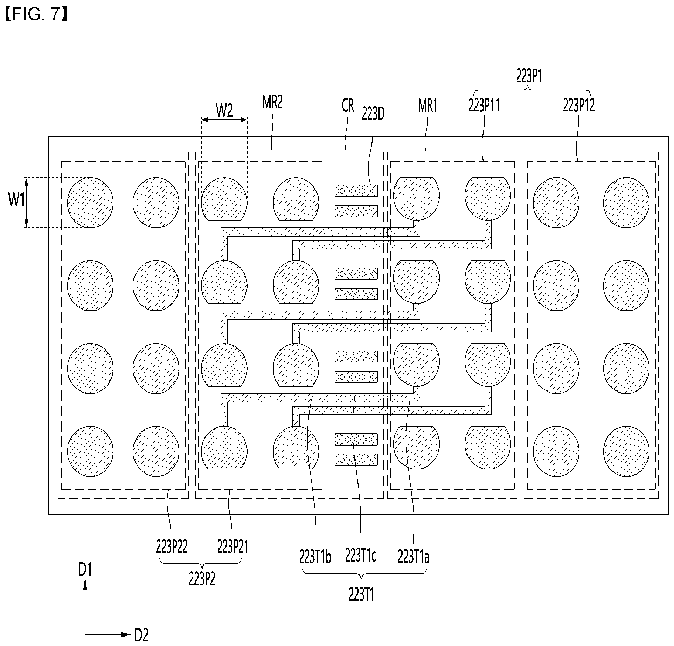

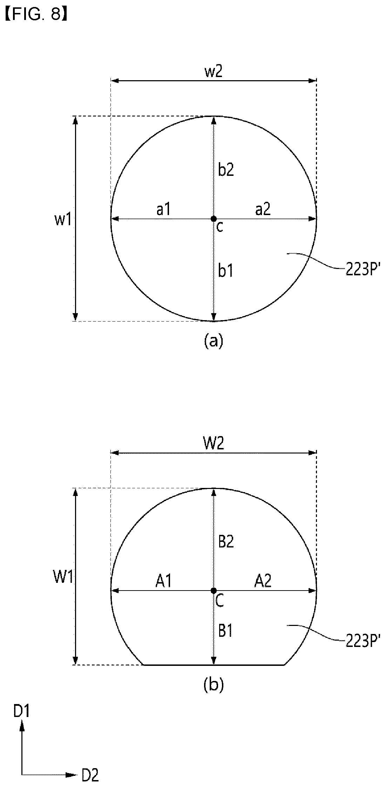

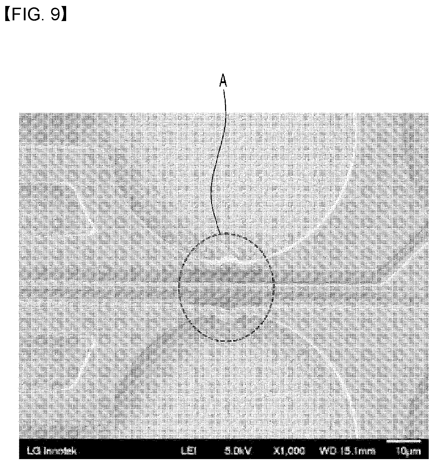

FIG. 7 is a plan view of an electrode portion of an embodiment, FIG. 8a is a view for comparing pad shapes of electrode portions of the comparative example and the embodiment, FIG. 8b is a view for explaining problems caused by a pad shape of an electrode portion of a comparative example, and FIG. 9 is an enlarged view of one region of FIG. 7.

Hereinafter, an electrode portion of an embodiment will be described in detail with reference to FIGS. 7 to 9.

The second substrate layer 200 includes a device mounting region R1. In addition, the device mounting region R1 includes a first mounting region MR1 vertically overlapping a first semiconductor device. In addition, the device mounting region R1 includes a second mounting region MR2 vertically overlapping a second semiconductor device. In addition, the device mounting region R1 includes a connection region CR between the first mounting region M1 and the second mounting region MR2. The connection region CR may vertically overlap a separation region between the first and second semiconductor devices.

In addition, an electrode portion 223 may be disposed in the device mounting region R1. The electrode portion 223 means a circuit pattern layer disposed on an uppermost side among the second circuit pattern layers 220 of the second substrate layer 200.

The electrode portion 223 may include a pad 223P and a trace 223T1. For example, the electrode portion 223 may include a pad 223P on which a connection portion (eg, solder ball) is disposed for mounting a semiconductor device, and a trace 223T1 electrically connecting a plurality of pads.

The pads 223P and the trace 223T1 are classified according to their functions.

For example, the pad 223P enables a semiconductor device to be mounted or attached thereto. The pad 223P means an electrode on which a connection portion such as a solder ball for mounting a semiconductor device is disposed. The trace 223T1 means a signal transmission line. For example, the trace 223T1 may be a connection electrode electrically connecting a plurality of pads.

In addition, the pad 223P and the trace 223T1 may be classified according to their shape or size.

For example, a shape of the pad 223P is different from that of the trace 223T1. In addition, a width of the pad 223P in a horizontal direction is different from that of the trace 223T1 in the horizontal direction.

The pad 223P has a curved portion on at least a part of a circumference of an upper surface thereof. The trace 223T1 does not have a curved portion on at least a part of a circumference of an upper surface thereof.

The pad 223P has a width greater than or equal to a certain level for mounting a semiconductor device. The trace 223T1 has a width smaller than that of the pad 223P, and thus, it is possible to arrange as many signal transmission lines as possible in a limited region.

For example, the electrode portion 223 includes a first pad portion 223P1 disposed in the first mounting region MR1, a second pad portion 223P2 disposed in the second mounting region MR2, and a trace 223T1 connecting the first pad portion 223P1 and the second pad portion 223P2 and disposed in the connection region CR.

The first pad portion 223P1 vertically overlaps a first semiconductor device disposed in the first mounting region MR1. The first pad portion 223P1 is electrically connected to a terminal provided in the first semiconductor device.

The second pad portion 223P2 vertically overlaps a second semiconductor device disposed in the second mounting region MR2. The second pad portion 223P2 is electrically connected to a terminal provided in the second semiconductor device.

The trace 223T1 electrically connects the first pad portion 223P1 and the second pad portion 223P2.

Specifically, the first semiconductor device and the second semiconductor device are electrically connected to each other and exchange electrical signals with each other. For example, at least one of a plurality of terminals of the first semiconductor device is electrically connected to at least one of a plurality of terminals of the second semiconductor device, so that communication is performed between the first and second semiconductor devices.

For example, the first semiconductor device includes a plurality of terminals. In addition, the plurality of terminals of the first semiconductor device include at least one first terminal electrically connected to the second semiconductor device and a second terminal excluding the first terminal. In addition, the plurality of terminals of the second semiconductor device include a third terminal electrically connected to the first terminal of the first semiconductor device and a fourth terminal excluding the third terminal.

The first pad portion 223P1 includes a first group of pads 223P11 vertically overlapping the first terminal of the first semiconductor device. In addition, the first pad portion 223P1 includes a second group of pads 223P12 vertically overlapping the second terminal of the first semiconductor device.

In this case, the first group of the pads 223P11 of the first pad portion 223P1 has a shape, width, and planar area different from at least one of a shape, width, and planar area of the second group of the pads 223P12 of the first pad portion 223P1.

That is, the first group of the pads 223P11 of the first pad portion 223P1 are connected to the plurality of traces 223T1, and thus have a relatively small width. For example, the first group of the pads 223P11 of the first pad portion 223P1 are provided in a region with a relatively high circuit density (circuit dense region), and accordingly, it must have a relatively small width and/or planar area. In contrast, the second group of the pads 223P12 of the first pad portion 223P1 are provided in a region with a lower circuit density than the first group of the pads 223P11, and accordingly, it may have a greater width and/or greater area than the first group of pads 223P11.

Accordingly, the embodiment allows the first group of pads 223P11 and the second group of pads 223P11 of the first pad portion 223P1 to have different shapes, widths, or planar areas.

In addition, the second pad portion 223P2 includes a first group of pads 223P21 vertically overlapping the third terminal of the second semiconductor device. In addition, the second pad portion 223P2 includes a second group of pads 223P22 vertically overlapping the fourth terminal of the second semiconductor device.

In this case, the first group of the pads 223P21 of the second pad portion 223P2 has a shape, width and planar area different from at least one of the shape, width and planar area of the second group of the pads 223P22 of the second pad portion 223P2.

That is, the first group of the pads 223P21 of the second pad portion 223P2 are connected to the plurality of traces 223T1 and accordingly, it should have a relatively small width. For example, the first group of the pads 223P21 of the second pad portion 223P2 are provided in a region with a relatively high circuit density (circuit dense region), and it must have a relatively small width and/or planar area. In contrast, the second group of the pads 223P22 of the second pad portion 223P2 are provided in a region with a lower circuit density than the first group of the pads 223P21, and accordingly, it may have a greater width and/or greater area than the first group of pads 223P21.

Accordingly, the embodiment allows the first group of pads 223P21 and the second group of pads 223P21 of the second pad portion 223P2 to have different shapes, widths, or planar areas.

For example, a planar shape of the first group of pads 223P11 and 223P21 of each of the first and second pad portions 223P1 and 223P2 may have a semicircular shape, and a planar shape of the second group of pads 223P12 and 223P22 of each of the first and second pad portions 223P1 and 223P2 may have a circular shape.

Hereinafter, the first group of pads 223P11 and 223P21 of each of the first and second pad portions 223P1 and 223P2 will be described in detail. Hereinafter, the first group of pads 223P11 and 223P21 of each of the first and second pad portions 223P1 and 223P2 will be referred to as a "pad 223P" for description.

A width W1 of the pad 223P in a first direction D1 may be different from a width W2 of the pad 223P in a second direction D2. For example, a width W1 of the pad 223P in the first direction D1 may be smaller than the width W2 in the second direction D2. In this case, the first direction D1 may mean an x-axis direction or a longitudinal direction. The second direction D2 may be perpendicular to the first direction D1. For example, the second direction D2 may mean a y-axis direction or a width direction. The first direction D1 may refer to a direction in which a trace 223T1 adjacent to the pad 223P is positioned.

For example, the first direction D1 refers to a direction in which the trace 223T1 adjacent to the pad 223P is disposed with respect to the pad 223P. The second direction D2 may mean a direction perpendicular to the first direction D1.

A width W2 of the pad 223P in the second direction D2 may satisfy a range of 20 µm to 80 µm. For example, a width W2 of the pad 223P in the second direction D2 may satisfy a range of 25 µm to 75 µm. For example, a width W2 of the pad 223P in the second direction D2 may satisfy a range of 30 µm to 70 µm. When the width W2 of the pad 223P in the second direction D2 is less than 20 µm, it may be difficult to stably arrange a connection portion for mounting a semiconductor device on the pad 223P. In addition, when the width W2 of the pad 223P in the second direction D2 exceeds 80 µm, it may be difficult to place all the pads connected to the terminals of the first and second semiconductor devices within the limited space. For example, when the width W2 of the pad 223P in the second direction D2 exceeds 80 µm, a size of the circuit board in the horizontal direction may increase.

A width W1 of the pad 223P in the first direction D1 may be smaller than a width W2 in the second direction D2. For example, a width W1 of the pad 223P in the first direction D1 may satisfy a range of 80% to 95% of a width W2 in the second direction D2. For example, a width W1 of the pad 223P in the first direction D1 may satisfy a range of 82% to 93% of a width W2 in the second direction D2. For example, a width W1 of the pad 223P in the first direction D1 may satisfy a range of 83% to 92% of a width W2 in the second direction D2.

Specifically, a width W1 of the pad 223P in the first direction D1 may satisfy a range of 16 µm to 76 µm. For example, a width W1 of the pad 223P in the first direction D1 may satisfy a range of 20.5 µm to 70 µm. For example, a width W1 of the pad 223P in the first direction D1 may satisfy a range of 25 µm to 58 µm. When the width W1 of the pad 223P in the first direction D1 is less than 16 µm, it may be difficult to stably arrange a connection portion for mounting a semiconductor device on the pad 223P. When the width W1 of the pad 223P in the first direction D1 exceeds 76 µm, physical and/or electrical reliability of traces disposed between the plurality of pads spaced apart in the first direction D1 may deteriorate. For example, when the width W1 of the pad 223P in the first direction D1 exceeds 76 µm, an arrangement for a plurality of traces may not be secured between the plurality of pads spaced apart in the first direction D1. In addition, when an arrangement space for a plurality of traces is not secured, pattern formation defects may occur in a process of forming traces. For example, when the arrangement space for a plurality of traces is not secured, defects such as distorted traces may occur. In addition, when the arrangement space for a plurality of traces is not secured, an electrical short problem may occur in which traces and pads or a plurality of traces disposed adjacent to each other are connected to each other.

As described above, the pad 223P of the embodiment may have a shape in which a portion where an adjacent trace is disposed is cut off based on a circular shape having a specific radius of curvature. For example, the pad 223P of the embodiment may have a shape in which 5% to 20% of an entire region of a circle having a specific radius of curvature is removed or cut. In addition, the removed or cut region of the entire region of the pad 223P may be a region adjacent to a region where the trace is disposed.

In this case, a pad 223P' of the circuit board of the comparative example has a circular shape having a specific radius of curvature as shown in (a) of FIG. 8. FIG. 8A (a) shows a first group of pads in a pad portion provided in a comparative example. For example, a width w1 of the pad 223P' of the comparative example in the first direction D1 is same as a width w2 in the second direction D2. That is, the first group of the pads of the comparative example have the same circular shape as the pads of the second group.

For example, the pads 223P' of the comparative example have the same widths w1 and w2 in the first and second directions D1 and D2 within a range of 20 µm to 80 µm. For example, the pad 223P' of the comparative example has the same width (b1) in a -first direction, width (b2) in a +first direction, width (a1) in a - second direction, and width (a2) in a +second direction from a center (c) of a circle having a specific radius of curvature.

Accordingly, the comparative example has a problem in that exposure defects and development defects of a dry film (not shown), or pattern groove defects occur in a region (A) between the plurality of pads spaced apart in the first direction (D1) as shown in FIG. 9. Accordingly, it is difficult to arrange a plurality of traces having high electrical and physical reliability between the plurality of pads spaced apart in the first direction D1 in the circuit board of the comparative example.

Alternatively, the pad 223P of the circuit board according to the embodiment may have a shape in which a portion where an adjacent trace is disposed is cut off based on a circular shape having a specific radius of curvature as shown in (b) of FIG. 8. For example, a width W1 of the pad 223P of the circuit board of the embodiment in the first direction D1 is different from a width W2 in the second direction D2. For example, the pad 223P of the circuit board according to the embodiment has a width W1 in the first direction D1 smaller than a width W2 in the second direction D2. For example, a width B2 in a +first direction, a width A1 in a - second direction, and a width A2 in a +second direction from a center (C) of a circle having a specific radius of curvature of the pad 223P of the embodiment is same as the radius of the circle, and a width B1 in a -first direction is smaller than the radius of the circle. Accordingly, the embodiment allows stable arrangement of a plurality of traces between a plurality of pads spaced apart in the first direction D1 in a state in which the physical and electrical reliability of the pad 223P is maintained as much as possible through the shape change of the pad 223P as described above.

Meanwhile, differently from the embodiment, a shape of the first group of pads may be changed to an elliptical shape. However, when the shape of the pad has an elliptical shape, various physical and electrical reliability problems may occur. For example, an entire region of the pad should overlap vertically with a through electrode disposed on its lower side. However, when the shape of the pad has an elliptical shape, at least a part of the pad may not vertically overlap a through electrode due to tolerances in a process of forming the pad, thereby causing electrical reliability and physical reliability problems. In addition, when the pad has an elliptical shape, a stress applied to the pad due to thermal stress may be skewed to one side, thereby deteriorating physical reliability at high temperatures.

Accordingly, the pad 223P of the embodiment has a shape in which only a region adjacent to the trace is cut off in a circle having a specific radius of curvature, and thus physical and electrical reliability can be improved.

The above-described pad 223P refers to the first group of pads 223P11 and 223P21 of each of the first and second pad portions 223P1 and 223P2.

In contrast, the second group of pads 223P12 and 223P22 of each of the first and second pad portions 223P1 and 223P2 have a circular shape unlike the first group of pads 223P11 and 223P21. Accordingly, the embodiment can improve a coupling strength between the second group of pads 223P12 and 223P22 of each of the first and second pad portions 223P1 and 223P2 and the first and second semiconductor devices, so that it is possible to stably operate the first and second semiconductor devices.

Hereinafter, the pad 223P corresponding to the second group of pads 223P12 and 223P22 of the first and second pad portions 223P1 and 223P2 will be described in detail.

A circumference of an upper surface 223PU of the pad 223P includes a curved portion having a specific radius of curvature and a straight portion connected to the curved portion. In this case, the straight portion of the circumference of the upper surface 223PU may be referred to as a first portion 223PU1, and the curved portion may be referred to as a second portion 223PU2.

One end of the second portion 223PU2 may be connected to one end of a straight line of the first portion 223PU1, and the other end of the second portion 223PU2 may be connected to the other end of the straight line of the first portion 223PU1. For example, the second portion 223PU2 of the pad 223P may connect one end and the other end of the first portion 223PU1 while having a specific radius of curvature.

The first portion 223PU1 of the upper surface 223PU of the pad 223P may refer to a region adjacent to the trace 223T1 among the entire region of the upper surface 223PU of the pad 223P. In this case, the first portion 223PU1 of the upper surface 223PU of the pad 223P may be parallel to the trace 223T1. For example, an extending direction of the straight line of the first portion 223PU1 of the upper surface 223PU of the pad 223P may be in a direction parallel to an extending direction of the trace 223T1 adjacent to the pad 223P. Here, a parallel direction may mean that a difference between an angle at which the first portion 223PU1 extends and an angle at which the trace 223T1 extends is 10 degrees or less, 8 degrees or less, 5 degrees or less, or 2 degrees or less.

That is, the pad 223P may include a first pad 223Pa and a second pad 223Pb spaced apart in the first direction D1. In addition, the first pad 223Pa and the second pad 223Pb may mean a first group of pads 223P11 of the first pad portion 223P1 or a first group of pads 223P21 of the second pad portion 223P2.

The first portion 223PU1 of the first pad 223Pa may be a region adjacent to the trace 223T1 disposed adjacently in the first direction D1. The first portion of the first pad 223Pa may face a second portion of the second pad 223Pb. For example, a second portion of the second pad 223Pb may be positioned in a region adjacent to the trace 223T1. That is, the second pad 223Pb may not include a straight portion on a circumference of an upper surface facing the first portion, which is the straight portion of the first pad 223Pa. In addition, when there is no additional third pad spaced apart from the second pad 223Pb in the first direction, a circumference of an upper surface of the second pad 223Pb may not include a straight portion. However, it is assumed in the following description that an additional third pad spaced apart from the second pad 223Pb in a first direction (e.g. downwards in the drawing) exists and at least a part of the circumference of the upper surface of the second pad 223Pb includes a straight portion. However, the embodiment is not limited thereto, and a circumference of an upper surface of the second pad 223Pb includes only a curved portion and may not include a straight portion.

Meanwhile, when the first portion, which is a straight portion, is included on a circumference of the upper surface of the second pad 223Pb, and the first portion of each of the first pad 223Pa and the second pad 223Pb are disposed facing each other, a space for arranging traces can be sufficiently secured in a region where the first portion faces each other. However, a space in which a trace is disposed may not be sufficiently provided in a space between the third pad 223Pb and the second pad 223Pb spaced apart from the second pad 223Pb in the first direction in this case, and accordingly, a physical or electrical reliability problem may occur.

That is, a plurality of traces may be disposed extending in a second direction D2 between the first pad 223Pa and the second pad 223Pb.

In this case, a pitch W3 between the first pad 223Pa and the second pad 223Pb may mean a straight distance between a center of the first pad and a center of the second pad in a first direction. A pitch W3 may satisfy a range of 25 µm to 110 µm. For example, a pitch W3 may satisfy a range of 31 µm to 100 µm. For example, a pitch W3 may satisfy a range of 37 µm to 90 µm. When the pitch W3 is less than 25 µm, it may be difficult to stably arrange the plurality of traces 223T1 between the first pad 223Pa and the second pad 223Pb spaced apart in the first direction D1. When the pitch W3 exceeds 110 µm, a space between the first pad 223Pa and the second pad 223Pb becomes too great, and accordingly, the size of the circuit board in the horizontal direction may increase.

A trace 223T1 includes a first portion 223T1a disposed in the first mounting region MR1 and connected to the first pad portion 223P1. In addition, a trace 223T1 includes a second portion 223T1b disposed in the second mounting region MR2 and connected to the second pad portion 223P2. In addition, the trace 223T1 may include a third portion 223T1c disposed in the connection region CR and connecting the first portion 223T1a and the second portion 223T1b.

In this case, as described above, ultra-miniaturization of the trace 223T1 is required for mounting of the first semiconductor device, mounting of the second semiconductor device, and connection between the first and second semiconductor devices within a limited space. To this end, the embodiment forms the second insulating layer 210 with the PID, so that the trace 223T1 can be ultra-miniaturized.

Preferably, a line width W4 of the trace 223T1 may satisfy a range of 1 µm to 6 µm. For example, a line width W4 of the trace 223T1 may satisfy a range of 1.2 µm to 5 µm. For example, a line width W4 of the trace 223T1 may satisfy a range of 1.5 µm to 4 µm. When the line width W4 of the trace 223T1 is smaller than 1 µm, the resistance of the trace 223T1 increases, and thus a normal electrical connection with a semiconductor device may be difficult. In addition, when the line width W4 of the trace 223T1 is smaller than 1 µm, implementation of the trace 223T1 is difficult, and a reliability problem in that the trace 223T1 easily collapses due to various factors may occur. When the line width W4 of the trace 223T1 is greater than 6 µm, it may be difficult to connect a plurality of semiconductor devices within a limited space. For example, when the line width W4 of the trace 223T1 is greater than 6 µm, it may be difficult to arrange all the traces for connecting a plurality of semiconductor devices within a limited space. For example, when the line width W4 of the trace 223T1 is greater than 6 µm, a space for arranging a trace for connecting a plurality of semiconductor devices within the connection region CR increases, and accordingly, a size of the circuit board and the semiconductor package may increase.

Meanwhile, a spacing W6 between the plurality of traces 223T1 or a spacing W5 between the pad 223P and the trace 223T1 may range from 1 µm to 6 µm. A spacing W6 between the plurality of traces 223T1 or a spacing W5 between the pad 223P and the trace 223T1 may range from 1.2 µm to 5 µm. A spacing W6 between the plurality of traces 223T1 or a spacing W5 between the pad 223P and the trace 223T1 may range from 1.5 µm to 4 µm. When the spacing W6 between the plurality of traces 223T1 or the spacing W5 between the pad 223P and the trace 223T1 is smaller than 1 µm, there is a problem that an electrical short occurs when adjacent traces or traces and pads are connected to each other. For example, when the spacing W6 between the plurality of traces 223T1 or the spacing W5 between the pad 223P and the trace 223T1 is greater than 6 µm, it may be difficult to arrange all the traces for connecting a plurality of semiconductor devices within a limited space.

Accordingly, when the two traces 223T1 are disposed in the second direction D2 between the first pad 223Pa and the second pad 223P, a width W7 of a trace arrangement space may range from 3 µm to 18 µm. For example, a width W7 of a trace arrangement space may range from 3.6 µm to 15 µm. For example, a width W7 of a trace arrangement space may range from 4.5 µm to 12 µm.

In addition, a width W8 between the first pad 223Pa and the second pad 223Pb in the first direction D1 or a spacing W8 between the first pad 223Pa and the second pad 223Pb spaced apart in the first direction D1 may range from 5 µm to 30 µm. For example, a spacing W8 between the first pad 223Pa and the second pad 223Pb spaced apart in the first direction D1 may range from 6 µm to 25 µm. For example, a spacing W8 between the first pad 223Pa and the second pad 223Pb spaced apart in the first direction D1 may range from 7.5 µm to 20 µm.

Meanwhile, the electrode portion 223 may include a dummy electrode 223D. The dummy electrode 223D is not electrically connected to the pad 223P and the trace 223T1 of the electrode portion 223. For example, the dummy electrode 223D is not electrically connected to the pad 223P and the trace 223T1, and thus may not be an electrode that transmits an electrical signal. The dummy electrode 223D may be disposed in the first connection region CR1. For example, the dummy electrode 223D may be disposed in a region not disposed on the trace 223T1 in the first connection region CR1. A line width of the dummy electrode 223D may be greater than that of the trace 223T1. The dummy electrode 223D may be formed for flatness of the circuit board. For example, an additional insulating layer (eg, a protective layer such as a solder resist) may be disposed on the electrode portion 223. Further, a height difference may occur between a region vertically overlapping the electrode portion 223 and a region not vertically overlapping the electrode portion 223 in the additional insulating layer in a state in which the dummy electrode 223D is not included. In addition, the flatness of the circuit board may be deteriorated due to the height difference. Accordingly, the embodiment minimizes the height difference of the additional insulating layer by using the dummy electrode 223D, thereby improving the flatness of the circuit board.

As described above, the first group of pads 223P11 and 223P21 of each of the first and second pad portions 223P1 and 223P2 of the embodiment may have a shape in which a region adjacent to an adjacent trace is cut off in a circle having a specific radius of curvature. For example, an upper surface 223PU of the first group of pads 223P11 and 223P21 of each of the first and second pad portions 223P1 and 223P2 includes a first portion 223PU1 adjacent to the trace and having a straight line. In addition, an upper surface 223PU of the first group of pads 223P11 and 223P21 of each of the first and second pad portions 223P1 and 223P2 includes a second portion 223PU2 of a curve connected to the first portion 223PU1 and having a specific radius of curvature. In addition, an extending direction of the straight line of the first portion 223PU1 may be the same as or parallel to an extending direction of the trace 223T1. Accordingly, the embodiment may secure an arrangement space for a plurality of traces between a plurality of pads spaced apart in the first direction D1 through a change in a shape of the first group of pads 223P11 and 223P21 of each of the first and second pad portions 223P1 and 223P2. Accordingly, the embodiment may allow the trace to be stably formed between a plurality of pads spaced apart in the first direction D1, and accordingly, physical and electrical reliability of the circuit board can be improved.

In addition, the pads 223P12 and 223P22 of the second group of each of the first and second pad portions 223P1 and 223P2 according to the embodiment may not include a straight portion but only a curved portion. Alternatively, the second group of pads 223P12 and 223P22 of each of the first and second pad portions 223P1 and 223P2 of the embodiment may have a greater planar area than that of the first group of pads. Through this, the embodiment can stably mount a semiconductor device.

Hereinafter, a method of manufacturing a circuit board according to an embodiment will be described.

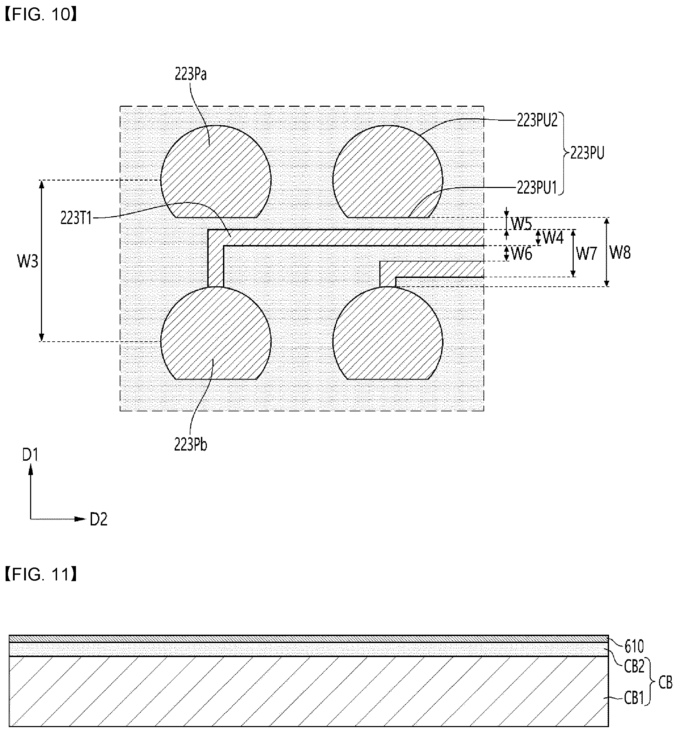

FIGS. 11 to 30 are views for explaining the circuit board of FIG. 1 in order of processes.

The manufacturing method of the circuit board according to the embodiment can be divided into a first process of manufacturing the first substrate layer 100 and a second process of manufacturing the second substrate layer 200 on the manufactured first substrate layer 100.

Referring to FIG. 11, the embodiment may proceed with a process of preparing a base member for manufacturing the first substrate layer 100 using the ETS method. To this end, the embodiment may prepare a carrier board (CB). The carrier board CB may include a carrier insulating layer CB1 and a carrier metal layer CB2 disposed on at least one surface of the carrier insulating layer CB1. In this case, it is shown that the carrier metal layer CB2 is disposed only on the first surface of the carrier insulating layer CB1 in the drawing, but the embodiment is not limited thereto. For example, the carrier board CB of the embodiment may include a carrier metal layer CB2 disposed on a first surface and a second surface opposite to the first surface of the carrier insulating layer CB1. In addition, when a carrier metal layer is formed on both sides of the carrier insulating layer CB1, a manufacturing process of the first substrate layer 100 described below may be performed on both sides of the carrier board CB, respectively. For example, the embodiment may allow the following processes to be performed on each of the upper and lower sides of the carrier board CB, and thus, a plurality of first substrate layers can be formed at one time.

The carrier metal layer CB2 may be formed by performing electroless plating on the carrier insulating layer CB1. In addition, the embodiment may use CCL (Copper Clad Laminate) as a carrier board (CB).

Next, the embodiment may proceed with a process of forming a first metal layer 610 on the carrier metal layer CB2. The first metal layer 610 may be formed to have a predetermined thickness on the carrier metal layer CB2 by performing a chemical copper plating process.

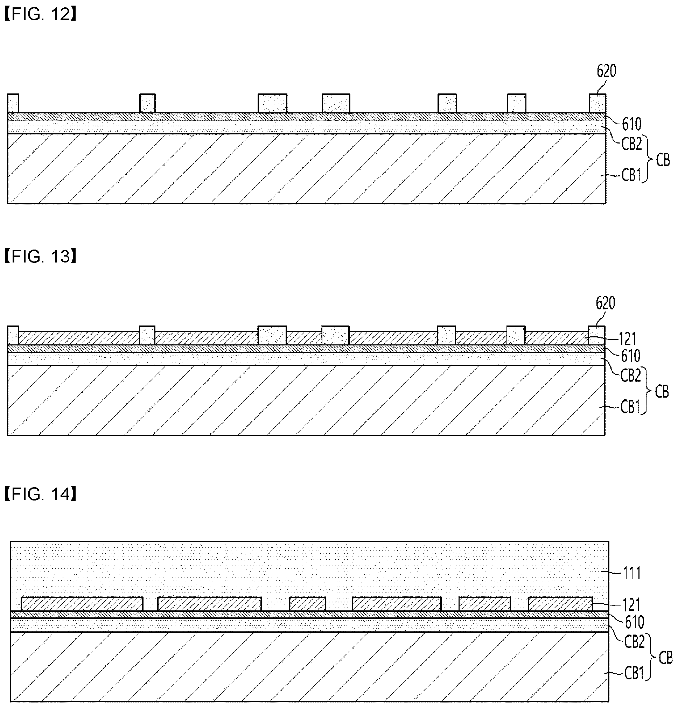

Subsequently, the embodiment may proceed with a process of forming a first mask 620 on the first metal layer 610 as shown in FIG. 12. In this case, the first mask 620 may be formed to entirely cover a first surface of the first metal layer 610, and thereafter, an opening (not shown) may be included to partially expose a surface of the first metal layer 610 through a process of opening the first mask. That is, the first mask 620 may include an opening (not shown) opening a region in which a first-first circuit pattern layer 121 is to be formed on a first surface of the first metal layer 610.

Subsequently, the embodiment may proceed with a process of forming the first-first circuit pattern layer 121 filling the opening of the first mask 620 by performing electroplating using the first metal layer 610 as a seed layer as shown in FIG. 13.

Subsequently, the embodiment may proceed with a process of removing the first mask 620 disposed on the first metal layer 610 as shown in FIG. 14. In addition, the embodiment may proceed with a process of forming a first-first insulating layer 111 covering the first-first circuit pattern layer 121 on the first metal layer 610. The first-first insulating layer 111 may include prepreg.

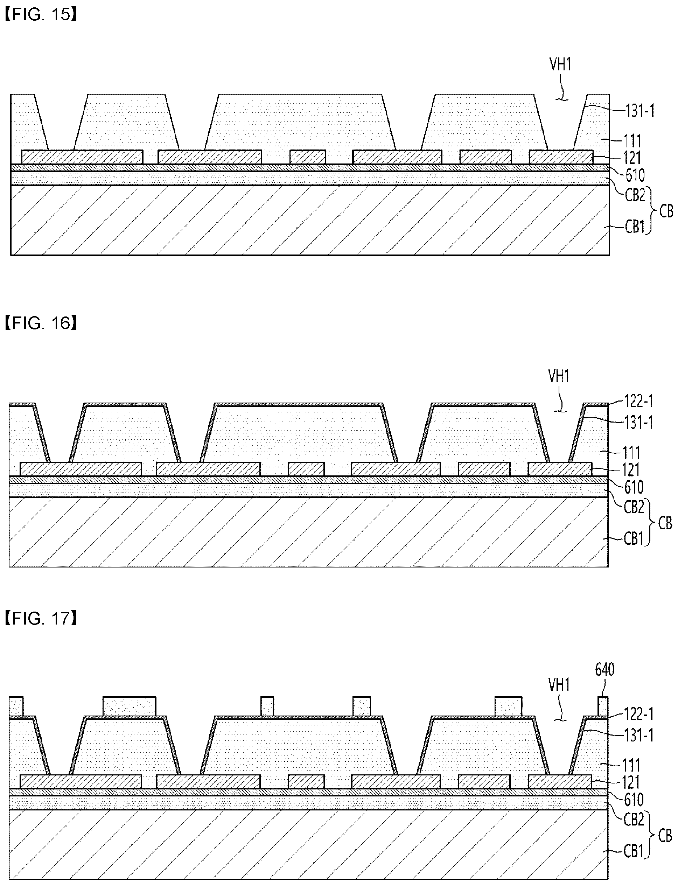

Subsequently, the embodiment may proceed with a process of forming a first-first through hole VH1 in the first-first insulating layer 111 as shown in FIG. 15. The first-first through hole VH1 may be formed through a laser process to open a resin and a reinforcing fiber constituting the first-first insulating layer 111.

Next, the embodiment may proceed with a process of forming first metal layers 131-1 and 122-1 on a surface of the first-first insulating layer 111 and an inner wall of the first-first through hole VH1 as shown in FIG. 16. The first metal layers 131-1 and 122-1 may be formed by a chemical copper plating process, but are not limited thereto.

Next, the embodiment may proceed with a process of forming a second mask 630 on the first metal layer 122-1 formed on the surface of the first-first insulating layer 111 as shown in FIG. 17. In this case, the second mask 630 may include at least one opening (not shown). For example, the second mask 630 may include an opening exposing a region where a first-first through electrode 131 is to be formed and an opening exposing a region where a first-second circuit pattern layer 122 is to be formed.

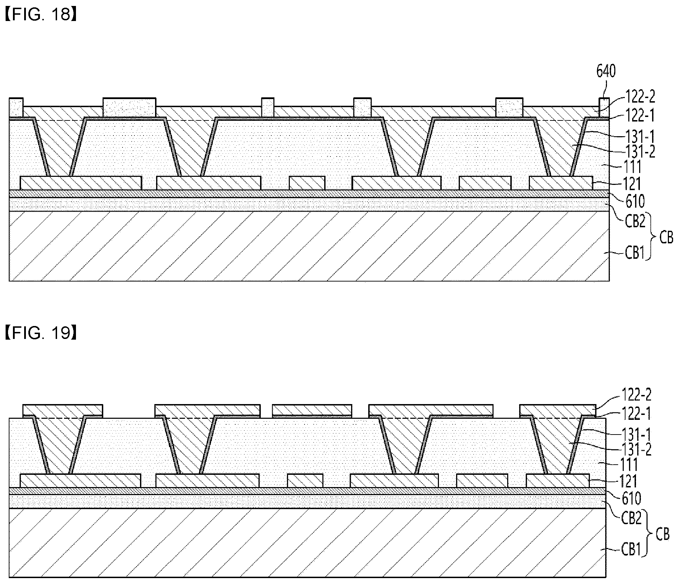

Next, the embodiment may proceed with a process of forming second metal layers 131-2 and 122-2 filling the opening of the second mask 630 by performing electroplating using the first metal layers 131-1 and 122-1 as shown in FIG. 18. In this case, the first metal layer 131-1 and the second metal layer 131-2 may constitute a first-first through electrode 131. In addition, the first metal layer 121-1 and the second metal layer 121-2 may constitute a first-second circuit pattern layer 122.

Next, the embodiment may proceed with a process of removing the second mask 630 and a process of etching the first metal layer 122-1 as shown in FIG. 19. For example, the embodiment may proceed with a process of etching the seed layer to remove a portion of the first metal layer 122-1 that does not overlap in the vertical direction with the second metal layer 122-2.

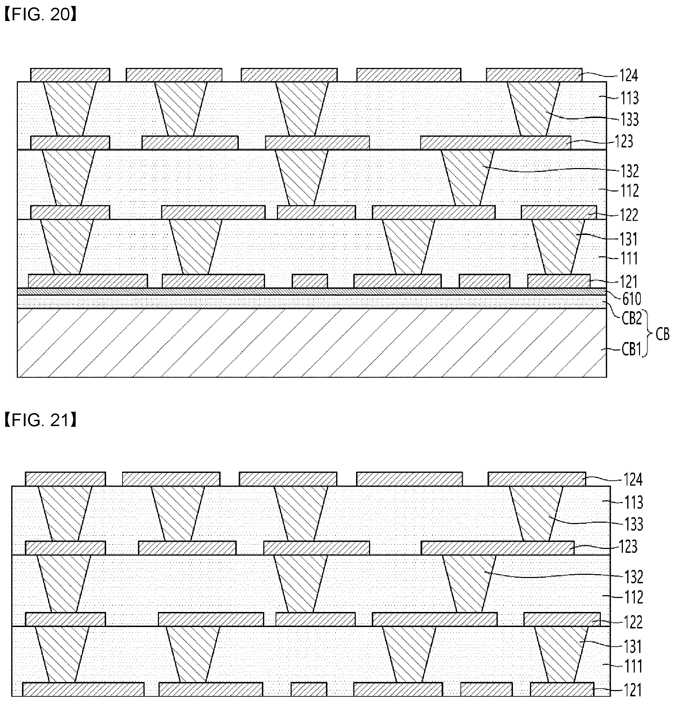

Next, the embodiment may proceed with a process of forming a multilayered first substrate layer 100 by repeating the processes of FIGS. 12 to 19 as shown in FIG. 20.

For example, the embodiment may proceed with a process of forming the first-second insulating layer 112 on the first-first insulating layer 111. In addition, the embodiment may proceed with a process of forming the first-second through electrode 132 and the first-third circuit pattern layer 123 on the first-second insulating layer 112. For example, the embodiment may proceed with a process of forming a first-third insulating layer 113 on the first-second insulating layer 112. In addition, the embodiment may proceed with a process of forming the first-third through electrode 133 and the first-fourth circuit pattern layer 124 on the first-third insulating layer 113.

Next, when the manufacturing of the first substrate layer 100 is completed, the embodiment may proceed with a process of removing the carrier board CB as shown in FIG. 21. In addition, when the carrier board CB is removed, the embodiment may proceed with a process of etching and removing the first metal layer 610, which is a seed layer of the first-first circuit pattern layer 121 formed on the first-first insulating layer 111. As described above, the embodiment may manufacture the first substrate layer 100 by performing the processes of FIGS. 11 to 21.

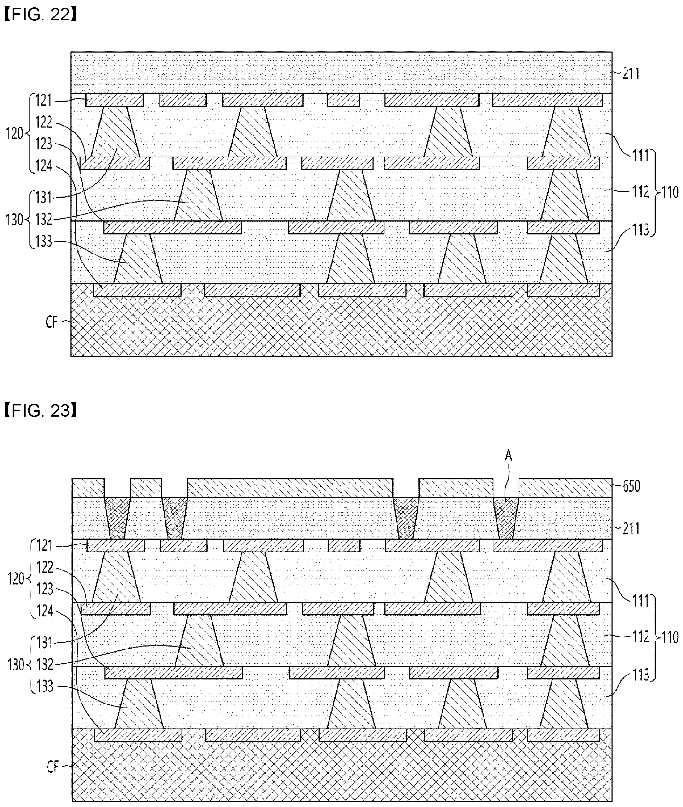

Next, the embodiment may proceed with a process of laminating a second-first insulating layer 211 on the first-first insulating layer 111 of the first substrate layer 100 as shown in FIG. 22. In this case, the second-first insulating layer 211 may include an insulating material different from that of the first-first insulating layer 111. For example, the second-first insulating layer 211 may include a PID. The second-first insulating layer 211 may be disposed to cover an ETS pattern of the first substrate layer 100. Specifically, the second-first insulating layer 211 may be disposed covering a first surface of the first-first insulating layer 111 and a first surface of the first-first circuit pattern layer 121.

Meanwhile, the embodiment may proceed with a process of forming a carrier film CF on a surface opposite to a surface on which a second-first insulating layer 211 is to be disposed. For example, the embodiment may proceed with a process of forming the carrier film CF on the second surface of the first-third insulating layer 113 of the first substrate layer 100. The carrier film CF may protect the first-third insulating layer 113 and the first-third circuit pattern layer 123 during a proceed of manufacturing the second substrate layer 200 that will be performed below.

Next, the embodiment may proceed with a process of exposing the second-first insulating layer 211 as shown in FIG. 23. To this end, the embodiment may proceed with a process of forming a third mask 650 on the second-first insulating layer 211. In this case, the third mask 650 may include an opening (not shown) corresponding to a region where a second-first through electrode 231 is to be formed. Thereafter, the embodiment may proceed with a process of exposing the partial region A of the second-first insulating layer 211 exposed through the opening of the third mask 650.

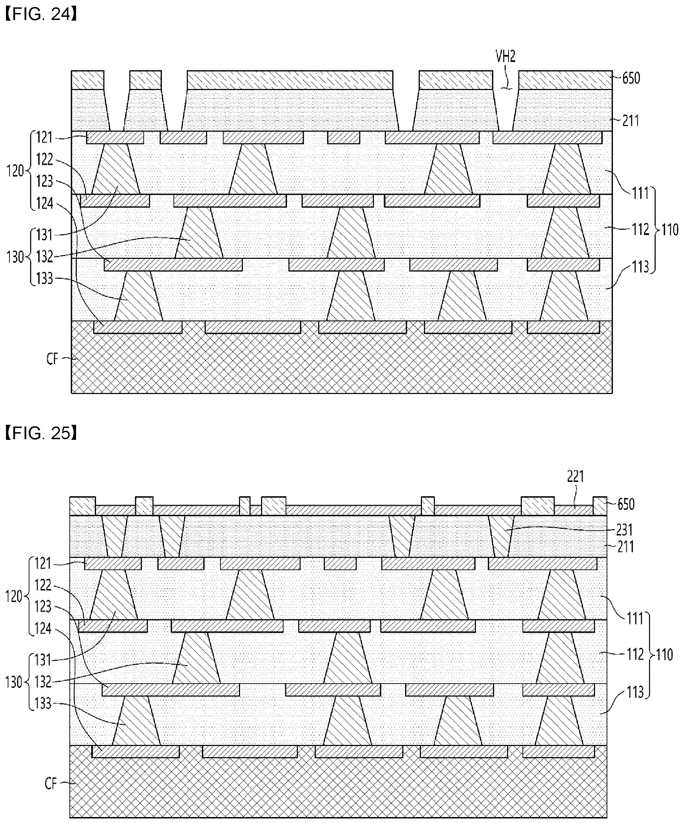

Next, the embodiment may proceed with a process of developing a region A and a process of removing a part of the region A as shown in FIG. 24. In addition, the embodiment may proceed with a process of forming the second-first through hole VH2 in the second-first insulating layer 211 by removing part of the region A.

Next, the embodiment may proceed with a process of forming a second-first through electrode 231 and a second-first circuit pattern layer 221 by forming a third mask 650 on the first-first insulating layer 211 and performing a plating process to fill the opening of the third mask 650 as shown in FIG. 25. In this case, a process of manufacturing the second-first through electrode 231 and the second-first circuit pattern layer 221 may include sequentially forming a first metal layer 220-1 containing titanium, a second metal layer 220-2 containing copper, and a third metal layer 220-3 containing copper.

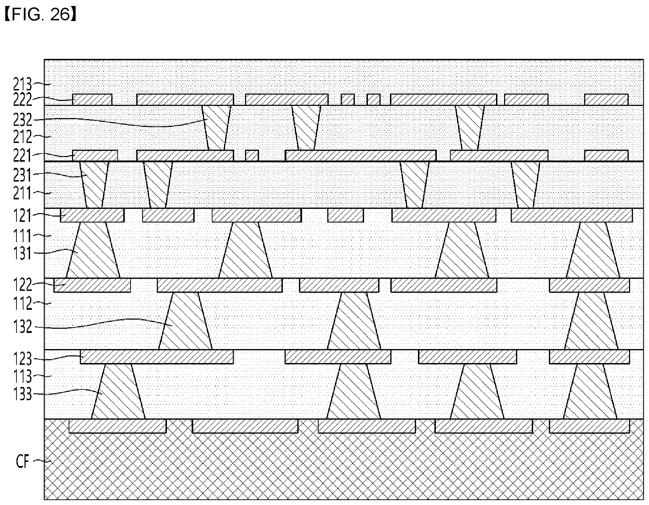

Next, the embodiment may proceed with a process of removing the third mask 650 as shown in FIG. 26. Next, the embodiment may proceed with a process of forming the second-second insulating layer 212 on the second-first insulating layer 211. Then, the embodiment may proceed with a process of forming the second-second through electrode 232 and the second-second circuit pattern layer 222 on the second-second insulating layer 212. Next, the embodiment may proceed with a process of forming a second-third insulating layer 213 on the second-second insulating layer 212.

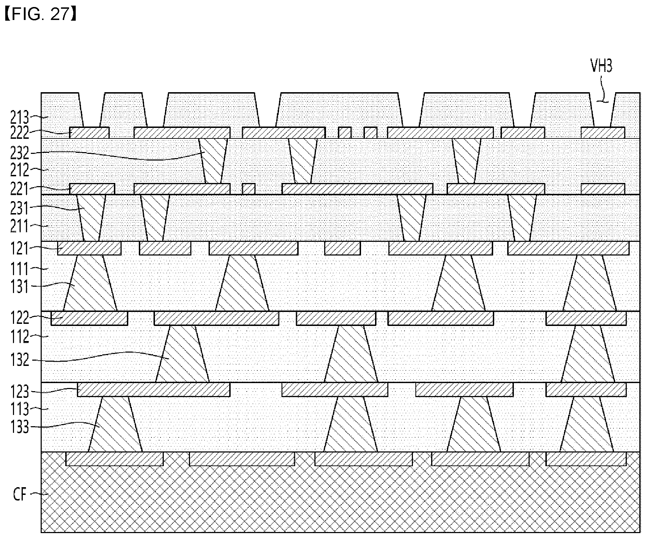

Next, the embodiment may proceed with a process of forming a second-third through hole VH3 in the second-third insulating layer 213 by performing a first exposure and developing process as shown in FIG. 27.

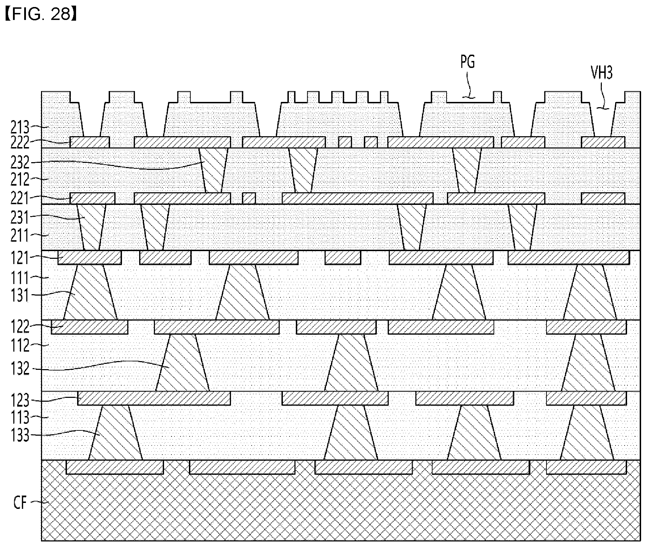

Next, the embodiment may proceed with a process of forming pattern grooves PG on a surface of the second-third insulating layer 213 by performing secondary exposure and development processes as shown in FIG. 28. In this case, conditions of the first exposure and development may be different from conditions of the second exposure and development. For example, the first exposure and development may proceed with conditions for forming a second-third through hole VH3 passing through the second-third insulating layer 213. For example, the second exposure and development may proceed with conditions for forming pattern grooves PG having a predetermined depth on a surface of the second-third insulating layer 213. Meanwhile, the embodiment may simultaneously proceed with the process of forming the second-third through hole (VH3) and the pattern groove (PG) using a mask (not shown) having different transmittance for each region. In addition, the pattern groove PG includes a portion corresponding to a pad 223P and a portion corresponding to a trace 223T1. In addition, the pattern groove PG corresponding to the pad 223P may have a shape as described above.

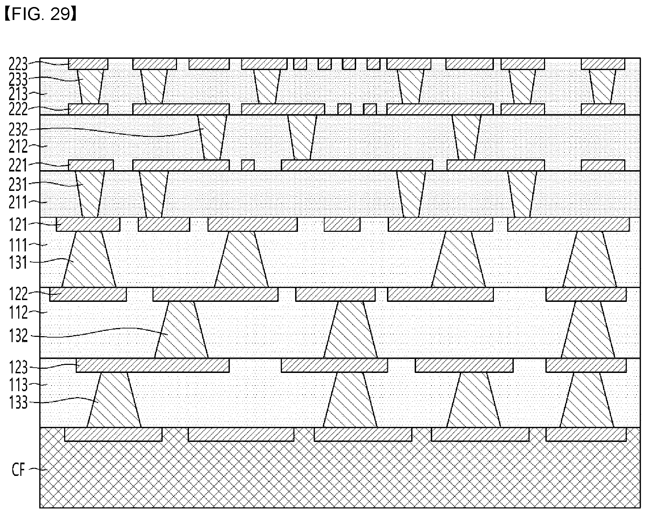

Next, the embodiment may proceed with a process of forming a second-third through electrode 233 and a second-third circuit pattern layer 223 positioned on an outermost side of the second substrate layer 200 by proceeding with the plating process to fill the second-third through hole (VH3) and pattern groove (PG) as shown in FIG. 29. The second-third circuit pattern layer 223 may be an electrode portion including a pad 223P and a trace 223T1.

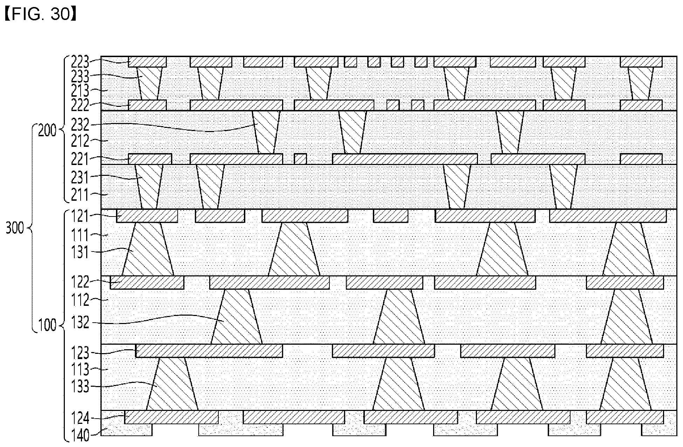

Next, the embodiment may proceed with a process of removing the carrier film (CF) formed on a lower side of the first substrate layer 100 and a process of forming a protective layer 140 including an opening on a second surface of the first-third insulating layer 113 as shown in FIG. 30.

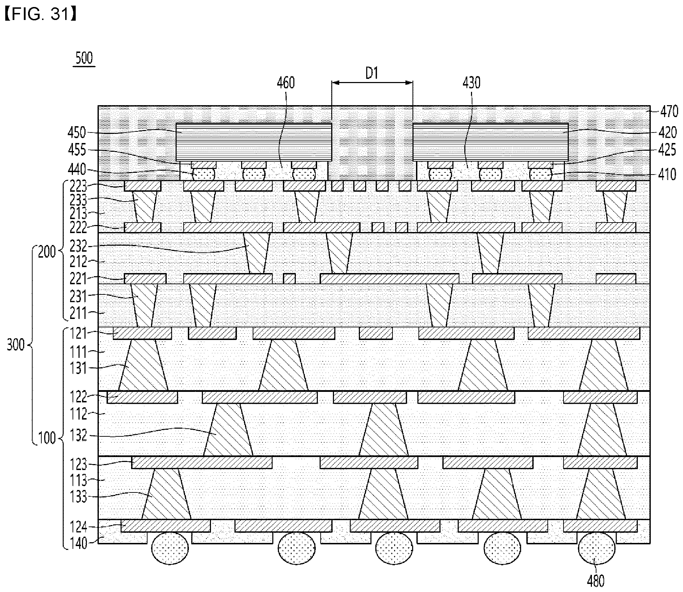

FIG. 31 is a view showing a semiconductor package according to a first embodiment.

Referring to FIG. 31, the embodiment may have a structure in which a plurality of semiconductor devices are mounted on the circuit board 300 of FIG. 2.

For example, a semiconductor package 500 may include a first connection portion 410 disposed on the first pad portion 223P1 of the second-third circuit pattern layer 223 (for example, the electrode portion) disposed on an outermost side of the second substrate layer 200. In addition, the semiconductor package 500 may include a second connection portion 440 disposed on the second pad portion 223P2 of the second-third circuit pattern layer 223 disposed on an outermost side of the second substrate layer 200.

The first connection portion 410 and the second connection portion 440 may have the same shape or may have different shapes.

For example, the first connection portion 410 and the second connection portion 440 may have a hexahedral shape. For example, a cross section of the first connection portion 410 and the second connection portion 440 may include a rectangular shape. A cross section of the first connection portion 410 and the second connection portion 440 may include a rectangle or a square. For example, the first connection portion 410 and the second connection portion 440 may have a spherical shape. For example, a cross section of the first connection portion 410 and the second connection portion 440 may include a circular shape or a semicircular shape. For example, a cross section of the first connection portion 410 and the second connection portion 440 may partially or entirely include a rounded shape. A cross-sectional shape of the first connection portion 410 and the second connection portion 440 may be flat on one side and curved on the other side. The first connection portion 410 and the second connection portion 440 may be solder balls, but are not limited thereto.

An embodiment may include a first semiconductor device 420 disposed on the first connection portion 410. The first semiconductor device 420 may be a first processor chip. For example, the first semiconductor device 420 may be an application processor (AP) chip of any one of a central processor (eg, CPU), a graphics processor (eg, GPU), a digital signal processor, a cryptographic processor, a microprocessor, and a microcontroller. A terminal 425 of the first semiconductor device 420 may be electrically connected to the first pad portion 223P1 through the first connection portion 410.

In addition, the embodiment may include a second semiconductor device 450 disposed on the second connection portion 440. The second semiconductor device 450 may be a second processor chip. For example, the second semiconductor device 450 may an application processor (AP) chip of a different type form the first semiconductor device 420 among a central processor (eg, CPU), a graphics processor (eg, GPU), a digital signal processor, a cryptographic processor, a microprocessor, and a microcontroller. A terminal 455 of the second semiconductor device 450 may be electrically connected to the second pad portion 223P2 through the second connection portion 440.

For example, the first semiconductor device 420 may be a central processor chip and the second semiconductor device 450 may be a graphics processor chip, but are not limited thereto.

Meanwhile, the first semiconductor device 420 and the second semiconductor device 450 may be disposed on the circuit board 300 with a first separation width D1. The first separation width D1 may be 150 µm or less. For example, the first separation width D1 may be 120 µm or less. For example, the first separation width D1 may be 100 µm or less.

Preferably, the first separation width D1 may have a range of 60 µm to 150 µm. Preferably, the first separation width D1 may have a range of 70 µm to 120 µm. Preferably, the first separation width D1 may have a range of 80 µm to 110 µm. When the first separation width D1 is smaller than 60 µm, interference between the first semiconductor device 420 and the second semiconductor device 420 may occur, and a problem may occur in operation reliability of the first semiconductor device 420 or the second semiconductor device 420. When the first separation width D1 is smaller than 60 µm, all wires for connecting the first semiconductor device 420 and the second semiconductor device 420 may not be disposed within a space corresponding to the first separation width D1. When the first separation width D1 is greater than 150 µm, signal transmission loss may increase as a distance between the first semiconductor device 420 and the second semiconductor device 420 increases. When the first separation width D1 is greater than 150 µm, a volume of the semiconductor package 500 may increase.

The semiconductor package 500 may include a first fillet layer 430 and a second fillet layer 460. The first fillet layer 430 may be disposed to surround the first substrate layer 100 and a terminal 425 of the first semiconductor device 420. The first fillet layer 430 may prevent foreign substances (eg, moisture) from penetrating into a space between the circuit board and the first semiconductor device 420. The second fillet layer 460 may be disposed to surround the first substrate layer 100 and a terminal 455 of the second semiconductor device 420. The second fillet layer 460 may prevent foreign substances (eg, moisture) from penetrating into a space between the circuit board and the second semiconductor device 420.

The semiconductor package 500 may include a molding layer 470. The molding layer 470 may be disposed to cover the first semiconductor device 420 and the second semiconductor device 420. For example, the molding layer 470 may be an epoxy mold compound (EMC) formed to protect the mounted first semiconductor device 420 and the second semiconductor device 420, but is not limited thereto.

The molding layer 470 may directly contact the first surface of the second-third insulating layer 213 disposed on an uppermost side of the circuit board. Here, a solder resist is not disposed on the first surface of the second-third insulating layer 213, and accordingly, a first surface of the second-third insulating layer 213 may directly contact the molding layer 470. In this case, the molding layer 470 may have a low dielectric constant in order to increase heat dissipation property. For example, the dielectric constant (Dk) of the molding layer 470 may be 0.2 to 10. For example, the dielectric constant (Dk) of the molding layer 470 may be 0.5 to 8. For example, the dielectric constant (Dk) of the molding layer 470 may be 0.8 to 5. Accordingly, the embodiment may allow the molding layer 470 to have a low dielectric constant, so that heat dissipation property of heat generated from the first semiconductor device 420 and/or the second semiconductor device 420 may be improved. In addition, the embodiment may allow the electrode portion to include the dummy electrode 223D, so that the flatness of the molding layer 470 may be secured, and further, the flatness of the semiconductor package may be secured.

Meanwhile, the semiconductor package 500 may include a third connection portion 480 disposed on a lowermost side of the circuit board 300. The third connection portion 480 may be disposed on the second surface or lower surface of the first-fourth circuit pattern layer 124 exposed through the protective layer 140.

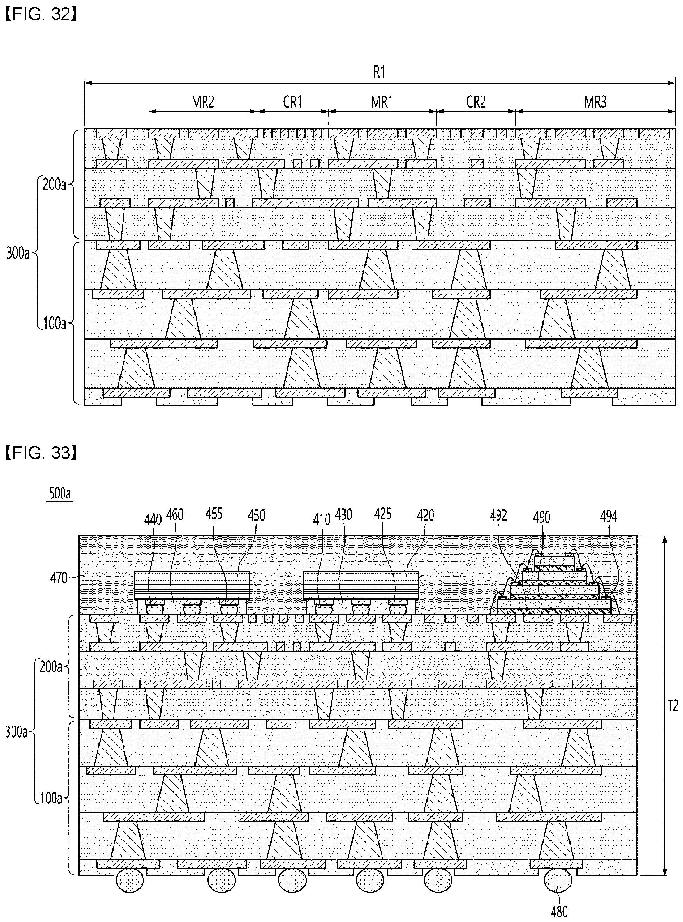

FIG. 32 is a view showing a circuit board according to a second embodiment.

Referring to FIG. 32, a circuit board 300a according to a second embodiment may further include a third mounting region MR3 in a device mounting region R1 compared to the circuit board 300 according to the first embodiment.

For example, the circuit board 300 according to the first and second embodiments provides two mounting regions in which a plurality of semiconductor devices of different types are mounted.

Alternatively, a circuit board 300a according to the second embodiment may provide at least three mounting regions in which at least three semiconductor devices are mounted.

The circuit board 300a may include a first substrate layer 100a and a second substrate layer 200a.

The first substrate layer 100a and the second substrate layer 200a are substantially the same as the first substrate layer 100 and the second substrate layer 200 of FIG. 1 or 2, and detailed description thereof will be omitted.

The device mounting region R1 of the second substrate layer 200a includes a first mounting region MR1 on which a first semiconductor device is mounted, a second mounting region MR2 on which a second semiconductor device of a different type from the first processor chip is mounted, a third mounting region (MR3) on which a third semiconductor device is mounted, a first connection region CR1 connecting the first mounting region MR1 and the second mounting region MR2, and a second connection region CR2 connecting the first mounting region MR1 and the third mounting region MR3.

That is, the embodiment provides a circuit board 300a on which at least three semiconductor devices (eg, a plurality of processor chips and at least one memory chip) can be mounted. This can be achieved as the insulating layer constituting the second substrate layer 200a includes the PID, and thus the circuit patterns of the second substrate layer 200a are ultra-miniaturized.

A second-third circuit pattern layer 223 (for example, the electrode portion) included in the second substrate layer 200a of the embodiment includes a third pad portion 223P3 disposed in the third mounting region MR3.

In addition, the second-third circuit pattern layer 223 included in the second substrate layer 200a of the embodiment may include a trace 223T2 disposed in the second connection region CR2 connecting the first pad portion 223P1 and the third pad portion 223P3.

In this case, a trace 223T1 in the first connection region CR1 according to an embodiment may have the same line width or spacing as a trace 223T2 in the second connection region CR2.

In addition, a trace 223T1 in the first connection region CR1 according to another embodiment may have a line width or spacing different from that of the trace 223T2 in the second connection region CR2. That is, the trace 223T1 in the first connection region CR1 needs to be ultra-miniaturized as described above for connection between the first and second semiconductor devices. Alternatively, the connection between the first and third semiconductor devices is made in the second connection region CR2. In this case, the number of connection wires in the second connection region CR2 is smaller than the number of connection wires in the first connection region CR1. Accordingly, the trace 223T2 in the second connection region CR2 may not require an ultra-refined line width or spacing as much as the trace 223T1 in the first connection region CR1.

Accordingly, the trace 223T2 in the second connection region CR2 may have a greater line width and spacing than the line width and spacing of the trace 223T1 in the first connection region CR1.

FIG. 33 is a view showing a semiconductor package according to a second embodiment.

Referring to FIG. 33, a semiconductor package 500a further includes a third semiconductor device compared to the semiconductor package 500 according to the first embodiment.

Specifically, the semiconductor package 500a includes a third semiconductor device 490 spaced apart from the first semiconductor device 420 by a predetermined distance and disposed side by side with the first semiconductor device 420. In this case, the third semiconductor device may have a multilayer structure with an adhesive layer 492 interposed therebetween. In addition, the semiconductor package 500a may include a connection member 494 connected to the third semiconductor device 490. The connection member 494 may be a wire, but is not limited thereto.

A thickness T2 of the semiconductor package 500a of the embodiment may be smaller than that of the semiconductor package of the comparative example. The thickness T2 of the semiconductor package 500a may be 95% of the thickness of the semiconductor package of the comparative example. The thickness T2 of the semiconductor package 500a may be 90% of the thickness of the semiconductor package of the comparative example. The thickness T2 of the semiconductor package 500a may be 85% of the thickness of the semiconductor package of the comparative example.

For example, the thickness T2 of the semiconductor package 500a may be less than 1000 µm. For example, the thickness T2 of the semiconductor package 500a may be less than 900 µm. For example, the thickness T2 of the semiconductor package 500a may be less than 850 µm.

The circuit board of an embodiment includes an electrode portion connected to a semiconductor device. The electrode portion includes a pad and a trace. In this case, the pad has a shape in which a region adjacent to the trace is cut in a circle having a specific radius of curvature. For example, a circumference of an upper surface of the pad includes a curved portion having a specific radius of curvature and a straight portion connected to the curved portion. The straight portion may be referred to as a first portion of the circumference of the upper surface of the pad, and the curved portion may be referred to as a second portion of the circumference of the pad. In addition, the first portion is disposed adjacent to the trace. In addition, an extension direction of a straight line of the first portion may be the same direction as or parallel to an extension direction of the trace. Accordingly, the embodiment may secure an arrangement space for a plurality of traces between a plurality of pads spaced apart in the first direction D1 by changing a shape of the circumferential of the upper surface of the pads. Accordingly, the embodiment may allow the trace to be stably formed between a plurality of pads spaced apart in the first direction D1, and accordingly, physical and electrical reliability of the circuit board can be improved.

Meanwhile, the pad of the embodiment are divided into a plurality of groups. For example, the pad includes a first group of pads and a second group of pads. In this case, the first group of the pads are provided in a region having a relatively high density, and thus have a shape in which a region adjacent to the trace is cut from a circle having the specific radius of curvature. In contrast, the second group of the pads are provided in a region having a relatively low density, and thus may have a circular shape with a plane area larger than that of the first group of the pads. Accordingly, the embodiment can stably mount a semiconductor device, so that the semiconductor device can stably operate.

In addition, the circuit board of the embodiment includes a first substrate layer and a second substrate layer. The second substrate layer may include a PID, and thus may include a fine pattern having a line width and spacing corresponding to a plurality of different semiconductor devices mounted on a circuit board. Accordingly, the embodiment may allow a plurality of different semiconductor devices to be mounted on one circuit board, furthermore, it is possible to easily connect the plurality of semiconductor devices within a limited space. Accordingly, the embodiment can improve the performance of the application processor by separating the plurality of semiconductor devices according to their functions. In addition, the embodiment can easily connect a plurality of semiconductor devices within a limited space, so that a volume of a semiconductor package can be reduced, and thus an electronic device can be slimmed down.

In addition, the embodiment may be possible to minimize a distance between the first and second semiconductor devices disposed on the circuit board. Accordingly, the embodiment can minimize loss of a signal transmitted between the first and second semiconductor devices, so that product reliability can be improved.

In addition, the embodiment may mount a plurality of semiconductor devices side by side on one substrate, and thus, a thickness of the semiconductor package may be drastically reduced compared to the comparative example.

In addition, the embodiment does not require connection of a plurality of circuit boards to connect a plurality of semiconductor devices, and therefore, it can improve the convenience of a process and the reliability of an electrical connection.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures, effects, and the like described in the above-described embodiments are included in at least one embodiment, but are not limited to only one embodiment. Furthermore, the characteristic, structure, and effect illustrated in each embodiment may be combined or modified for other embodiments by a person skilled in the art. Therefore, it should be construed that contents related to such combination and modification are included in the scope of the embodiment.

Embodiments are mostly described above, but the embodiments are merely examples and do not limit the embodiments, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the embodiment defined in the following claims.

## Claims

1. A semiconductor package comprising:
an insulating layer; and
an electrode portion disposed on the insulating layer,
wherein the electrode portion includes a plurality of pads and a trace connecting the plurality of pads, and
wherein the plurality of pads includes:
a first pad including a curved portion in which a circumference of an upper surface has a specific radius of curvature and a straight portion connected to the curved portion; and
a second pad that does not include a straight portion in a circumference of an upper surface facing the curved portion of the first pad.

2. The semiconductor package of claim 1, wherein the first pad includes a width in a second direction parallel to the straight portion and a width in a first direction perpendicular to the second direction, and
wherein the width in the first direction is smaller than the width in the second direction.

3. The semiconductor package of claim 1, wherein a width of the first pad in a-first direction from a center of the radius of curvature is smaller than each width of the first pad in a + first direction, a-second direction, and a + second direction from the center of the radius of curvature.

4. The semiconductor package of claim 3, wherein widths of the first pad in the + first direction,-second direction, and + second direction from the center of the radius of curvature are the same, respectively.

5. The semiconductor package of claim 1, wherein a width of the first pad in a first direction satisfies a range of 80% to 95% of a width of the first pad in a second direction.

6. The semiconductor package of claim 5, wherein the width in the first direction satisfies a range of 16 µm to 76 µm, and
wherein the width in the second direction satisfies a range of 20 µm to 80*µ*m.

7. The semiconductor package of claim 1 or 2, wherein a line width of the trace satisfies a range of 1 µm to 6 µm, and
wherein a spacing between the pad and the trace or a spacing between the plurality of traces satisfies a range of 1 µm to 6 µm.

8. The semiconductor package of claim 1, wherein the straight portion of the first pad is parallel to an extension direction of a trace connected to the second pad.

9. The semiconductor package of claim 7, wherein the first and second pads are spaced apart from each other in the first direction, and
wherein the trace extends between the first and second pads in the second direction.

10. The semiconductor package of claim 9, wherein at least two traces extending in the second direction and spaced apart from each other in the first direction are disposed between the first pad and the second pad.
